(19) Europäisches Patentamt / European Patent Office / Office européen des brevets

(11) **EP 4 346 233 B1**

(12) **EUROPEAN PATENT SPECIFICATION**


(45) Date of publication and mention of the grant of the patent:
**18.06.2025 Bulletin 2025/25**

(21) Application number: **23199921.0**

(22) Date of filing: **26.09.2023**

(51) International Patent Classification (IPC):
***H04R 29/00*** *(2006.01)* ***H03F 3/185*** *(2006.01)*
***H03F 3/217*** *(2006.01)*

(52) Cooperative Patent Classification (CPC):
**H04R 29/001; H03F 3/185; H03F 3/2173;**
H03F 2200/03; H03F 2200/331; H04R 2499/13


(54) **SEMICONDUCTOR DEVICE AND ELECTRONIC APPARATUS**

HALBLEITERBAUELEMENT UND ELEKTRONISCHE VORRICHTUNG

DISPOSITIF À SEMI-CONDUCTEUR ET APPAREIL ÉLECTRONIQUE


(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **27.09.2022 JP 2022153602**

(43) Date of publication of application:
**03.04.2024 Bulletin 2024/14**



(73) Proprietor: **Seiko Epson Corporation**
**Tokyo 160-8801 (JP)**

(72) Inventors:
- **KATAYAMA, Takao**
**Suwa-shi, 392-8502 (JP)**
- **FUKUZAWA, Akihiro**
**Suwa-shi, 392-8502 (JP)**
- **BAISHO, Fumihito**
**Suwa-shi, 392-8502 (JP)**
- **NONAKA, Tsutomu**
**Suwa-shi, 392-8502 (JP)**

(74) Representative: **Lewis Silkin LLP**
**Arbor**
**255 Blackfriars Road**
**London SE1 9AX (GB)**



(56) References cited:
**US-A1- 2011 241 774** **US-A1- 2012 294 450**
**US-A1- 2015 030 167** **US-A1- 2022 086 577**



Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).


EP 4 346 233 B1

## Description

BACKGROUND

1. Technical Field

The present disclosure relates to a semiconductor device and an electronic apparatus.

2. Related Art

JP-A-2012-199854 discloses a speaker failure notification device that measures an impedance changing with a structural change of a speaker, that determines whether the measured impedance is within a predetermined range, and that notifies that the speaker fails when it is determined that the impedance is not within the range by a control unit.

In the speaker failure notification device disclosed in JP-A-2012-199854, when measuring the impedance of the speaker, instead of using an amplifier that increases or decreases a level of an analog sound signal and outputs the increased or decreased level of the analog sound signal to the speaker, the control unit applies an alternating-current voltage having a predetermined frequency to the speaker via a dedicated physical quantity measuring device, measures a current that flows through the speaker, and calculates the impedance by a voltage/current. Therefore, in the speaker failure notification device disclosed in JP-A-2012-199854, the dedicated physical quantity measuring device is required to apply the alternating-current voltage having the predetermined frequency to the speaker to measure a current, and a circuit for measuring the impedance of the speaker is large.

US 2015/030167 A1 discloses a speaker failure detection device which determines the resonance frequency of a speaker connected to a class-D amplifier by measuring the impedance at the output of the amplifier.

US 2012/294450 A1 discloses using a high output impedance in an amplifier in order to determine the resonance frequency of a speaker by monitoring the output voltage without measuring the output current.

US 2011/241774 A1 discloses using parallel amplification stages in a class-D amplifier to increase the output power.

US 2022/086577 A1 discloses a class-D amplifier having two amplification stages which are selectively activated, one being used in a normal operation mode, and the other one being used in a fault detection mode and having a higher output resistance.

SUMMARY

A semiconductor device according to an aspect of the present disclosure includes:

a first output terminal coupled to a first terminal of a sound reproduction device;
a second output terminal coupled to a second terminal of the sound reproduction device;
a modulation circuit configured to modulate a signal based on a sound source signal to output a first modulated signal and a second modulated signal;
a first amplifier circuit configured to output a first amplified signal obtained by amplifying the first modulated signal to the first output terminal in a first operation mode;
a second amplifier circuit configured to output a second amplified signal obtained by amplifying the second modulated signal to the second output terminal in the first operation mode;
a test signal generation circuit configured to modulate a test signal in which a frequency is changed in a preset frequency band to generate a third modulated signal and a fourth modulated signal in a second operation mode; and
a peak frequency detection circuit configured to measure a potential difference between the first output terminal and the second output terminal, and detect a frequency range including a peak frequency that is the frequency of the test signal at which an impedance of the sound reproduction device peaks in the second operation mode, in which
the first amplifier circuit outputs a third amplified signal obtained by amplifying the third modulated signal to the first output terminal in the second operation mode,
the second amplifier circuit outputs a fourth amplified signal obtained by amplifying the fourth modulated signal to the second output terminal in the second operation mode,
the first amplifier circuit includes a plurality of inverter circuits each having an output terminal coupled to the first output terminal,
the second amplifier circuit includes a plurality of inverter circuits each having an output terminal coupled to the second output terminal,
in the first operation mode, the first modulated signal is input to input terminals of the plurality of inverter circuits provided in the first amplifier circuit, and the second modulated signal is input to input terminals of the plurality of inverter circuits provided in the second amplifier circuit, and
in the second operation mode, the third modulated signal is input to input terminals of some of the plurality of inverter circuits provided in the first amplifier circuit, output terminals of other inverter circuits among the plurality of inverter circuits provided in the first amplifier circuit have high impedances, the fourth modulated signal is input to input terminals of some of the plurality of inverter circuits provided in the second amplifier circuit, and output terminals of other inverter circuits among the plurality of inverter circuits provided in the second amplifier circuit have high impedances.

An electronic apparatus according to an aspect of the present disclosure includes:

the semiconductor device according to the aspect; and
the sound reproduction device.

BRIEF DESCRIPTION OF THE DRAWINGS

FIG. 1 is a diagram showing a configuration example of a semiconductor device according to a first embodiment.
FIG. 2 is a diagram showing an example of pulse-width modulation for generating a pulse-width modulated signal DOP.
FIG. 3 is a diagram showing an example of pulse-width modulation for generating a pulse-width modulated signal DON.
FIG. 4 is a diagram showing an example of a difference between the pulse-width modulated signal DOP and the pulse-width modulated signal DON.
FIG. 5 is a diagram showing an example of a relationship between a state of a speaker and impedance characteristics.
FIG. 6 is a diagram showing a configuration example of class-D amplifiers, a peak frequency detection circuit, and peripheral circuits thereof.
FIG. 7 is a diagram showing a configuration example of the class-D amplifiers, the peak frequency detection circuit, and the peripheral circuits thereof.
FIG. 8 is a diagram showing a configuration example of a differential low-pass filter and a comparator.
FIG. 9 is a diagram showing a truth table of an output signal of an encoder.
FIG. 10 is a flowchart showing an example of a procedure for measuring a start time point and an end time point of a frequency range including a peak frequency.
FIG. 11 is a diagram showing an example of generation of a test signal and measurement of the start time point and the end time point in the first embodiment.
FIG. 12 is a diagram showing an example of the generation of the test signal and the measurement of the start time point and the end time point in the first embodiment.
FIG. 13 is a diagram showing an example of the generation of the test signal and the measurement of the start time point and the end time point in the first embodiment.
FIG. 14 is a diagram showing an example of generation of the test signal and measurement of the start time point and the end time point in a second embodiment.
FIG. 15 is a diagram showing an example of generation of the test signal and measurement of the start time point and the end time point in a third embodiment.
FIG. 16 is a diagram showing a configuration example of a semiconductor device according to a fourth embodiment.
FIG. 17 is a flowchart showing an example of a procedure of processing performed by a failure detection circuit.
FIG. 18 is a diagram showing another example of the pulse-width modulation for generating the pulse-width modulated signal DON.
FIG. 19 is a diagram showing another example of the difference between the pulse-width modulated signal DOP and the pulse-width modulated signal DON.
FIG. 20 is a functional block diagram of an electronic apparatus according to the embodiment.
FIG. 21 is a diagram showing a configuration example of a warning device that is an example of the electronic apparatus.

DESCRIPTION OF EMBODIMENTS

Hereinafter, preferred embodiments of the present disclosure will be described in detail with reference to the drawings. The embodiments described below do not unduly limit content of the present disclosure disclosed in the claims. Further, all configurations described below may not be essential elements of the present disclosure.

1. Semiconductor Device

1-1. First Embodiment

FIG. 1 is a diagram showing a configuration example of the semiconductor device according to the first embodiment. As shown in FIG. 1, a semiconductor device 1 according to the first embodiment includes a communication interface circuit 10, a memory 20, switches 81 and 82, a sound source reproduction circuit 100, and an inspection circuit 110. The semiconductor device 1 may be a single-chip semiconductor integrated circuit device, may be implemented by a multi-chip semiconductor integrated circuit device, or at least a part thereof may be implemented by an electronic component other than the semiconductor integrated circuit device.

In the memory 20, n pieces of sound source data 21-1 to 21-n are stored. The n is an integer of one or more. The memory 20 may be, for example, a flash memory. Each piece of the sound source data 21-1 to 21-n may be, for example, pulse-code modulated sound data, or may be adaptive differential pulse-code modulated sound data. The sound source data 21-1 to 21-n may be, for example, data based on various sounds such as a sound imitating a voice when a person speaks, a mechanical warning sound, and a sound effect.

The communication interface circuit 10 is a circuit that performs data communication with a micro control unit 2. The communication interface circuit 10 may be, for example, an SPI interface circuit, or may be an I2C interface circuit. The SPI is an abbreviation for a serial peripheral interface, and the I2C is an abbreviation for an inter-integrated circuit.

The communication interface circuit 10 receives various commands transmitted from the micro control unit 2, and generates various control signals corresponding to the received commands. For example, when receiving a command for switching an operation mode of the semiconductor device 1 to a normal operation mode or an inspection mode, the communication interface circuit 10 generates a control signal for switching coupling of the switches 41 and 42 according to an operation mode. Further, for example, when receiving a sound source reproduction command for sound source data 21-i that is any one of the sound source data 21-1 to 21-n stored in the memory 20, the communication interface circuit 10 reads the sound source data 21-i from the memory 20, inputs the sound source data 21-i to the sound source reproduction circuit 100 as a sound source signal DI, and instructs the sound source reproduction circuit 100 to reproduce the sound source data 21-i. Further, for example, when receiving a sound source stop command for the sound source data 21-i in reproduction, the communication interface circuit 10 instructs the sound source reproduction circuit 100 to stop the reproduction. Further, for example, when receiving various setting commands related to the sound source reproduction, the communication interface circuit 10 performs various settings on the sound source reproduction circuit 100.

In the embodiment, the sound source signal DI input to the sound source reproduction circuit 100 is a pulse-code modulated signal. When the sound source data 21-1 to 21-n is compressed sound data or the adaptive differential pulse-code modulated sound data, the sound source data 21-i that is a reproduction target is converted into the sound source signal DI that is the pulse-code modulated signal by a decoder (not shown).

The sound source reproduction circuit 100 converts the sound source signal DI into amplified signals DOXP and DOXN that are sound signals, and outputs the amplified signals DOXP and DOXN to a sound reproduction device 3 coupled to the semiconductor device 1. Accordingly, sounds corresponding to the amplified signals DOXP and DOXN are output from the sound reproduction device 3. For example, the sound reproduction device 3 may be a speaker or a buzzer. The sound output from the sound reproduction device 3 may be, for example, a sound imitating a voice when a person speaks, or may be various sounds such as a mechanical warning sound or a sound effect.

As shown in FIG. 1, in the embodiment, the sound source reproduction circuit 100 includes a modulation circuit 30, switches 41 and 42, and an amplifier circuit 50.

The modulation circuit 30 receives the sound source signal DI, modulates a signal based on the sound source signal DI, and outputs pulse-width modulated signals DOP and DON. The signal based on the sound source signal DI may be the sound source signal DI itself, or a signal obtained by performing some processing on the sound source signal DI. In the embodiment, the modulation circuit 30 includes a digital filter 31, a sigma-delta modulation circuit 32, and a pulse-width modulation circuit 33.

The digital filter 31 is a low-pass filter that receives the sound source signal DI and outputs a signal DF obtained by reducing a high-frequency noise included in the sound source signal DI. The sigma-delta modulation circuit 32 receives the signal DF from the digital filter 31, and performs the sigma-delta modulation by oversampling the signal DF at an n-fold sampling ratio, thereby outputting the sigma-delta modulated signal DS in which a noise is biased in a high-frequency band. The n is an integer of two or more. Therefore, when a sampling frequency of the sound source signal DI is fs, a sampling frequency of the signal DF output from the digital filter 31 is fs, and a sampling frequency of the sigma-delta modulated signal DS is $n \times fs$. The digital filter 31 functions as an antialiasing filter for reducing a high-frequency noise folded back into a signal band due to oversampling of the sigma-delta modulation circuit 32.

The pulse-width modulation circuit 33 pulse-width modulates the sigma-delta modulated signal DS to output the pulse-width modulated signals DOP and DON. The pulse-width modulated signals DOP and DON are 1-bit digital signals. When the sampling frequency of the sigma-delta modulated signal DS is $n \times fs$, sampling frequencies of the pulse-width modulated signals DOP and DON are n × m × fs. Here, when the number of bits of the sigma-delta modulated signal DS is M, $m = 2^M$.

In this way, the modulation circuit 30 sigma-delta modulates a signal obtained by performing digital filter processing on the sound source signal DI, pulse-width modulates the signal, and outputs the pulse-width modulated signals DOP and DON.

The pulse-width modulation for generating the pulse-width modulated signal DOP and the pulse-width modulation for generating the pulse-width modulated signal DON are different in methods. FIG. 2 is a diagram showing an example of the pulse-width modulation for generating the pulse-width modulated signal DOP. Further, FIG. 3 is a diagram showing an example of the pulse-width modulation for generating the pulse-width modulated signal DON. FIGS. 2 and 3 show examples when the number of bits M of the sigma-delta modulated signal DS is 4. In FIGS. 2 and 3, the sigma-delta modulated signal DS is updated with a period T as a cycle, and the pulse-width modulated signals DOP and DON are at a high level or a low level in 16 sections T1 to T16 obtained by dividing the period T. That is, a length of the period T is 1/(n × fs), and a length of each of the sections T1 to T16 is 1/(n × m × fs).

As shown in FIG. 2, the larger the value of the sigma-delta modulated signal DS, the longer the pulse-width modulated signal DOP is at the high level. For example, when the sigma-delta modulated signal DS is decimal "-7", that is, binary "1001", the pulse-width modulated signal DOP is at the high level in the section T1, and is at the low level in the 15 sections T2 to T16. Further, for example, when the sigma-delta modulated signal DS is decimal "0", that is, binary "0000", the pulse-width modulated signal DOP is at the high level in the 8 sections T1 to T8, and is at the low level in the 8 sections T9 to T16. Further, for example, when the sigma-delta modulated signal DS is decimal "7", that is, binary "0111", the pulse-width modulated signal DOP is at the high level in the 15 sections T1 to T15, and is at the low level in the section T16.

As shown in FIG. 3, the larger the value of the sigma-delta modulated signal DS, the shorter the pulse-width modulated signal DON is at the high level. For example, when the sigma-delta modulated signal DS is decimal "-7", that is, binary "1001", the pulse-width modulated signal DON is at the high level in the 15 sections T1 to T15, and is at the low level in the section T16. Further, for example, when the sigma-delta modulated signal DS is decimal "0", that is, binary "0000", the pulse-width modulated signal DON is at the high level in the 8 sections T1 to T8, and is at the low level in the 8 sections T9 to T16. Further, for example, when the sigma-delta modulated signal DS is decimal "7", that is, binary "0111", the pulse-width modulated signal DON is at the high level in the section T1, and is at the low level in the 15 sections T2 to T16.

Therefore, for example, a difference between the pulse-width modulated signal DOP and the pulse-width modulated signal DON when the sigma-delta modulated signal DS is the decimal "-7", "0", or "7" is as shown in FIG. 4.

Returning to the description of FIG. 1, the switch 41 outputs any one of the pulse-width modulated signal DOP and a pulse-width modulated signal TP to a class-D amplifier 51P of the amplifier circuit 50 according to a control signal output from the communication interface circuit 10. Specifically, the switch 41 outputs the pulse-width modulated signal DOP to the class-D amplifier 51P when an operation mode of the semiconductor device 1 is the normal operation mode, and outputs the pulse-width modulated signal TP to the class-D amplifier 51P when an operation mode of the semiconductor device 1 is the inspection mode.

The switch 42 outputs any one of the pulse-width modulated signal DON and a pulse-width modulated signal TN to a class-D amplifier 51N of the amplifier circuit 50 according to a control signal output from the communication interface circuit 10. Specifically, the switch 42 outputs the pulse-width modulated signal DON to the class-D amplifier 51N when an operation mode of the semiconductor device 1 is the normal operation mode, and outputs the pulse-width modulated signal TN to the class-D amplifier 51N when an operation mode of the semiconductor device 1 is the inspection mode.

In the normal operation mode, the amplifier circuit 50 receives the pulse-width modulated signals DOP and DON, and outputs the amplified signals DOXP and DOXN obtained by amplifying the pulse-width modulated signals DOP and DON to output terminals 91 and 92 of the semiconductor device 1. Further, in the inspection mode, the amplifier circuit 50 receives the pulse-width modulated signals TP and TN, and outputs the amplified signals DOXP and DOXN obtained by amplifying the pulse-width modulated signals TP and TN to the output terminals 91 and 92 of the semiconductor device 1.

In the embodiment, the amplifier circuit 50 includes the two class-D amplifiers 51P and 51N. The class-D amplifier 51P outputs the amplified signal DOXP obtained by amplifying the pulse-width modulated signal DOP to the output terminal 91 in the normal operation mode, and outputs the amplified signal DOXP obtained by amplifying the pulse-width modulated signal TP to the output terminal 91 in the inspection mode. The class-D amplifier 51N outputs the amplified signal DOXN obtained by amplifying the pulse-width modulated signal DON to the output terminal 92 in the normal operation mode, and outputs the amplified signal DOXN obtained by amplifying the pulse-width modulated signal TN to the output terminal 92 in the inspection mode. The output terminal 91 is coupled to a terminal P1 of the sound reproduction device 3, and the output terminal 92 is coupled to a terminal P2 of the sound reproduction device 3. The sound reproduction device 3 reproduces a sound having a magnitude corresponding to a voltage difference between the amplified signal DOXP and the amplified signal DOXN.

The inspection circuit 110 is a circuit that inspects the sound reproduction device 3.

FIG. 5 is a diagram showing an example of relationship between a speaker state and impedance characteristics. In FIG. 5, a horizontal axis represents a frequency of an input signal of the speaker, and a vertical axis represents an impedance value of the speaker. G1 represents an example of impedance characteristics when the speaker is normal. A peak frequency f0 that is a frequency of an input signal at which an impedance of the speaker peaks varies depending on a type of the speaker. When the speaker is normal, the peak frequency f0 is included in at least a frequency band of 20 Hz or more that is a lower limit of a human audible range and 3 kHz or less that is a frequency used for a buzzer warning sound. G2 represents an example of impedance characteristics when a magnet of the speaker is in a broken and removed state. When the magnet is removed from the speaker, only a coil remains, and therefore the impedance value increases slowly as the frequency increases, and the peak frequency f0 disappears. G3 represents an example of impedance characteristics when a cone paper of the speaker is in a broken state. When the cone paper that is a vibration surface of the speaker is broken, a bass is not generated, and the peak frequency f0 shifts to a high frequency side.

In this way, the peak frequency f0 varies depending on a state of the speaker. Therefore, in the embodiment, the inspection circuit 110 detects a frequency range F0 including the peak frequency f0 in the inspection mode. In the embodiment, the inspection circuit 110 includes a test signal generation circuit 60 and a peak frequency detection circuit 70.

In the inspection mode, the test signal generation circuit 60 modulates a test signal in which a frequency is changed in a preset frequency band to generate the modulated signals TP and TN. The frequency band in which the test signal generation circuit 60 changes the frequency of the test signal can be freely set by the micro control unit 2, and may be, for example, a frequency band of 10 Hz or more and 3 kHz or less. In the embodiment, the test signal generation circuit 60 pulse-width modulates the test signal to generate the pulse-width modulated signals TP and TN. The pulse-width modulation method applied by the test signal generation circuit 60 is the same as the pulse-width modulation method applied by the pulse-width modulation circuit 33.

In the inspection mode, the peak frequency detection circuit 70 measures a potential difference between the output terminal 91 and the output terminal 92, and detects the frequency range F0 including the peak frequency f0. The peak frequency f0 is a frequency of a test signal at which an impedance of the sound reproduction device 3 peaks.

The switch 81 switches whether to electrically couple or decouple the output terminal 91 and the peak frequency detection circuit 70 of the semiconductor device 1 in response to a control signal output from the communication interface circuit 10. Specifically, the switch 81 electrically decouples the output terminal 91 from the peak frequency detection circuit 70 when an operation mode of the semiconductor device 1 is the normal operation mode, and electrically couples the output terminal 91 and the peak frequency detection circuit 70 when an operation mode of the semiconductor device 1 is the inspection mode.

The switch 82 switches whether to electrically couple or decouple the output terminal 92 and the peak frequency detection circuit 70 of the semiconductor device 1 in response to a control signal output from the communication interface circuit 10. Specifically, the switch 82 electrically decouples the output terminal 92 from the peak frequency detection circuit 70 when an operation mode of the semiconductor device 1 is the normal operation mode, and electrically couples the output terminal 92 and the peak frequency detection circuit 70 when an operation mode of the semiconductor device 1 is the inspection mode.

In this way, the peak frequency detection circuit 70 is electrically decoupled from the output terminals 91 and 92 in the normal operation mode by the switches 81 and 82, is electrically coupled to the output terminals 91 and 92 in the inspection mode, measures the potential difference between the output terminal 91 and the output terminal 92, and detects the frequency range F0 including the peak frequency f0.

When receiving a command for reading the frequency range F0 including the peak frequency f0 from the micro control unit 2, the communication interface circuit 10 acquires the frequency range F0 from the peak frequency detection circuit 70, and transmits the acquired frequency range F0 to the micro control unit 2. For example, the micro control unit 2 can determine presence or absence of a failure and a failure mode of the sound reproduction device 3 based on the frequency range F0.

FIGS. 6 and 7 are diagrams showing configuration examples of the class-D amplifiers 51P and 51N, the peak frequency detection circuit 70, and peripheral circuits thereof. FIG. 6 shows a configuration in the normal operation mode, and FIG. 7 shows a configuration in the inspection mode.

As shown in FIGS. 6 and 7, the class-D amplifier 51P includes a plurality of inverter circuits 201-1 to 201-n, and the class-D amplifier 51N includes a plurality of inverter circuits 202-1 to 202-n. n is an integer of 2 or more, and may be, for example, about 10 to 100. Each of the inverter circuits 201-1 to 201-n is implemented by a pair of PMOS transistor and NMOS transistor. An output terminal that is a node to which a drain of the PMOS transistor and a drain of the NMOS transistor are coupled is coupled to the output terminal 91. Similarly, each of the inverter circuits 202-1 to 202-n is implemented by a pair of the PMOS transistor and the NMOS transistor. An output terminal that is a node to which the drain of the PMOS transistor and the drain of the NMOS transistor are coupled is coupled to the output terminal 92.

As shown in FIG. 6, in the normal operation mode, the modulated signal DOP is input via the switch 41 to input terminals of the inverter circuits 201-1 to 201-n provided in the class-D amplifier 51P, and the modulated signal DON is input via the switch 42 to input terminals of the inverter circuits 202-1 to 202-n provided in the class-D amplifier 51N. That is, in the normal operation mode, the inverter circuits 201-1 to 201-n provided in the class-D amplifier 51P are coupled in parallel to one another between the modulation circuit 30 and the output terminal 91 of the semiconductor device 1, and the inverter circuits 202-1 to 202-n provided in the class-D amplifier 51N are coupled in parallel to one another between the modulation circuit 30 and the output terminal 92 of the semiconductor device 1. Accordingly, an on-resistance $R_{onP}$ of the class-D amplifier 51P is 1/n of an on-resistance of the inverter circuit 201-1, and an on-resistance $R_{onN}$ of the class-D amplifier 51N is 1/n of an on-resistance of the inverter circuit 202-1.

The amplifier circuit 50 outputs the amplified signal DOXP obtained by amplifying the modulated signal DOP to the output terminal 91, and outputs the amplified signal DOXN obtained by amplifying the modulated signal DON to the output terminal 92. The output terminals 91 and 92 are coupled to the terminals P1 and P2 of the sound reproduction device 3, respectively. An impedance $R_{sp}$ between the terminal P1 and the terminal P2 is, for example, 4 Ω to 128 Ω. In the normal operation mode, the on-resistance $R_{onP}$ of the class-D amplifier 51P and the on-resistance $R_{onN}$ of the class-D amplifier 51N are about 1/10 to 1/100 of the impedance $R_{sp}$ of the sound reproduction device 3.

As shown in FIG. 6, in the normal operation mode, the switches 81 and 82 are nonconductive, and the peak frequency detection circuit 70 is electrically decoupled from the output terminals 91 and 92 of the semiconductor device 1.

On the other hand, as shown in FIG. 7, in the inspection mode, the modulated signal TP is input via the switch 41 to the input terminals of some of the inverter circuits 201-1 to 201-n provided in the class-D amplifier 51P, and the output terminals of other inverter circuits 201-1 to 201-n have high impedances. For example, in the inspection mode, the modulated signal TP is input to the input terminal of the inverter circuit 201-1, and the output terminals of the inverter circuits 201-2 to 201-n have high impedances. Similarly, the modulated signal TN is input via the switch 42 to the input terminals of some of the inverter circuits 202-1 to 202-n provided in the class-D amplifier 51N, and the output terminals of other inverter circuits 202-1 to 202-n have high impedances. For example, in the inspection mode, the modulated signal TN is input to the input terminal of the inverter circuit 202-1, and the output terminals of the inverter circuits 202-2 to 202-n have high impedances. Accordingly, for example, the on-resistance $R_{onP}$ of the class-D amplifier 51P and the on-resistance $R_{onN}$ of the class-D amplifier 51N are about the same as the impedance $R_{sp}$.

As shown in FIG. 7, in the inspection mode, the switches 81 and 82 are conductive, and the peak frequency detection circuit 70 is electrically coupled to the output terminals 91 and 92 of the semiconductor device 1.

The peak frequency detection circuit 70 includes a differential low-pass filter 71, a comparator 72, and a peak time measurement circuit 73.

In the inspection mode, the differential low-pass filter 71 receives a voltage of the output terminal 91 and a voltage of the output terminal 92 via the switches 81 and 82. That is, the differential low-pass filter 71 receives the amplified signals DOXP and DOXN, reduces high-frequency noise components overlapped on the amplified signals DOXP and DOXN by the pulse-width modulation, and outputs a voltage V' corresponding to a potential difference between the amplified signals DOXP and DOXN. A cutoff frequency of the differential low-pass filter 71 is higher than a maximum frequency of a frequency band in which the test signal generation circuit 60 changes the frequency of the test signal. For example, when the test signal generation circuit 60 changes the frequency of the test signal in the frequency band of 10 Hz or more and 3 kHz or less, the cutoff frequency of the differential low-pass filter 71 is higher than 3 kHz. Since the cutoff frequency of the differential low-pass filter 71 is higher than the maximum frequency of the frequency band in which the frequency of the test signal is changed, a frequency component included in the frequency band is not attenuated by the differential low-pass filter 71.

The comparator 72 compares an output voltage of the differential low-pass filter 71 with at least one threshold voltage, and outputs data DT indicating a comparison result. The comparator 72 may be, for example, an analog/digital conversion circuit that compares the output voltage of the differential low-pass filter 71 with $2^m - 1$ threshold voltages and outputs an m-bit digital signal. m is an integer of 1 or more.

The peak time measurement circuit 73 measures a range including a time at which the potential difference between the output terminal 91 and the output terminal 92 is maximum based on the data DT that is an output signal of the comparator 72. For example, the peak time measurement circuit 73 may measure a start time point $t_{start}$ and an end time point $t_{stop}$ of the range as the range including the time at which the potential difference between the output terminal 91 and the output terminal 92 is maximum. When the frequency of the test signal increases over time in the frequency band of 10 Hz or more and 3 kHz or less, a frequency of the test signal at the start time point $t_{start}$ corresponds to a lower limit of the frequency range F0, and a frequency of the test signal at the end time point $t_{stop}$ corresponds to an upper limit of the frequency range F0.

In this way, in the inspection mode, the peak frequency detection circuit 70 detects the frequency range F0 including the peak frequency f0 by measuring the range including the time at which the potential difference between the output terminal 91 and the output terminal 92 is maximum. The frequency range F0 detected by the peak frequency detection circuit 70 may be the start time point $t_{start}$ and the end time point $t_{stop}$ of the range including the time at which the potential difference between the output terminal 91 and the output terminal 92 is maximum. Alternatively, the peak frequency detection circuit 70 may calculate a frequency range of the test signal corresponding to the start time point $t_{start}$ and the end time point $t_{stop}$ as the frequency range F0.

FIG. 8 is a diagram showing a configuration example of the differential low-pass filter 71 and the comparator 72.

As shown in FIG. 8, the differential low-pass filter 71 includes an operational amplifier 211, five resistors 212, 213, 214, 216, and 218, and three capacitors 215, 217, and 219.

In the inspection mode, the amplified signal DOXP output to the output terminal 91 of the semiconductor device 1 is input to one end of the resistor 212. Further, the amplified signal DOXN output to the output terminal 92 of the semiconductor device 1 is input to one end of the resistor 213. The other end of the resistor 212, one end of the resistor 214, and one end of the capacitor 215 are coupled to a non-inverting input terminal of the operational amplifier 211. The other end of the resistor 213, one end of the resistor 216, one end of the capacitor 217, one end of the resistor 218, and one end of the capacitor 219 are coupled to an inverting input terminal of the operational amplifier 211.

The other end of the resistor 214 and the other end of the capacitor 215 are coupled to an output terminal of the operational amplifier 211. The other end of the resistor 216 and the other end of the capacitor 217 are grounded. A power supply voltage is supplied to the other end of the resistor 218 and the other end of the capacitor 219.

The differential low-pass filter 71 implemented in this way reduces the high-frequency noise components overlapped on the amplified signals DOXP and DOXN by the pulse-width modulation, and outputs the voltage V' corresponding to the potential difference between the amplified signals DOXP and DOXN, that is, the potential difference between the output terminal 91 and the output terminal 92 from the output terminal of the operational amplifier 211. When the power supply voltage is VDD and a ground voltage is 0V, and when the potential difference between the output terminal 91 and the output terminal 92 at which the high-frequency noise components are reduced is positive, the voltage V' is higher than VDD $\times$ 1/2, and when the potential difference between the output terminal 91 and the output terminal 92 at which the high-frequency noise components are reduced is negative, the voltage V' is lower than VDD $\times$ 1/2.

There is a relationship of Equation (1) between an amplitude voltage V' (p - p) of the voltage V', and the impedance $R_{sp}$ of the sound reproduction device 3, the on-resistance $R_{onP}$ of the class-D amplifier 51P, as well as the on-resistance $R_{onN}$ of the class-D amplifier 51N. According to Equation (1), since the larger the impedance $R_{sp}$, the larger the amplitude of the voltage V', the amplitude of the voltage V' is maximum when the impedance $R_{sp}$ peaks.

$$V'(p-p) \propto \frac{R_{sp}}{R_{sp}+R_{onP}+R_{onN}} \times VDD \cdots (1)$$

The comparator 72 includes eight resistors 221 to 228, seven comparators 231 to 237, six logic elements 241 to 247, and an encoder 250.

The resistors 221 to 228 are coupled in series between a power supply and ground. Resistance values of the resistors 222 to 227 are the same. The resistors 221 and 228 are adjusted according to a set maximum value of the amplitude voltage V' (p - p) of the voltage V'. Here, in order to simplify the description, it is assumed that all the resistance values of the resistors 221 to 228 are the same. When the power supply voltage is VDD and the ground voltage is 0 V, a voltage of a coupling node between the resistor 221 and the resistor 222 is VDD $\times$ 7/8, a voltage of a coupling node between the resistor 222 and the resistor 223 is VDD $\times$ 6/8, a voltage of a coupling node between the resistor 223 and the resistor 224 is VDD $\times$ 5/8, a voltage of a coupling node between the resistor 224 and the resistor 225 is VDD $\times$ 4/8, a voltage of a coupling node between the resistor 225 and the resistor 226 is VDD $\times$ 3/8, a voltage of a coupling node between the resistor 226 and the resistor 227 is VDD $\times$ 2/8, and a voltage of a coupling node between the resistor 227 and the resistor 228 is VDD $\times$ 1/8.

When the voltage V' is higher than VDD $\times$ 7/8 that is the voltage of the coupling node between the resistor 221 and the resistor 222, an output signal of the comparator 231 is at a low level, or at a high level otherwise. When the voltage V' is higher than VDD $\times$ 6/8 that is the voltage of the coupling node between the resistor 222 and the resistor 223, an output signal of the comparator 232 is at a low level, or at a high level otherwise. When the voltage V' is higher than VDD $\times$ 5/8 that is the voltage of the coupling node between the resistor 223 and the resistor 224, an output signal of the comparator 233 is at a low level, or at a high level otherwise. When the voltage V' is higher than VDD $\times$ 4/8 that is the voltage of the coupling node between the resistor 224 and the resistor 225, an output signal of the comparator 234 is at a low level, or at a high level otherwise. When the voltage V' is higher than VDD $\times$ 3/8 that is the voltage of the coupling node between the resistor 225 and the resistor 226, an output signal of the comparator 235 is at a low level, or at a high level otherwise. When the voltage V' is higher than VDD $\times$ 2/8 that is the voltage of the coupling node between the resistor 226 and the resistor 227, an output signal of the comparator 236 is at a low level, or at a high level otherwise. When the voltage V' is higher than VDD $\times$ 1/8 that is the voltage of the coupling node between the resistor 227 and the resistor 228, an output signal of the comparator 237 is at a low level, or at a high level otherwise.

The logic element 241 outputs a low-level signal when the output signal of the comparator 231 is at the high level and the output signal of the comparator 232 is at the low level, and outputs a high-level signal in other cases. The logic element 242 outputs a low-level signal when the output signal of the comparator 232 is at the high level and the output signal of the comparator 233 is at the low level, and outputs a high-level signal in other cases. The logic element 243 outputs a low-level signal when the output signal of the comparator 233 is at the high level and the output signal of the comparator 234 is at the low level, and outputs a high-level signal in other cases. The logic element 244 outputs a low-level signal when the output signal of the comparator 234 is at the high level and the output signal of the comparator 235 is at the low level, and outputs a high-level signal in other cases. The logic element 245 outputs a low-level signal when the output signal of the comparator 235 is at the high level and the output signal of the comparator 236 is at the low level, and outputs a high-level signal in other cases. The logic element 246 outputs a low-level signal when the output signal of the comparator 236 is at the high level and the output signal of the comparator 237 is at the low level, and outputs a high-level signal in other cases.

Therefore, when the voltage V' is higher than VDD $\times$ 7/8, the output signals of the logic elements 241 to 247 are at the high level. Further, when the voltage V' is higher than VDD $\times$ 6/8 and lower than VDD $\times$ 7/8, the output signal of the logic element 241 is at the low level, and the output signals of the logic elements 242 to 247 are at the high level. Further, when the voltage V' is higher than VDD $\times$ 5/8 and lower than VDD $\times$ 6/8, the output signals of the logic elements 241 and 242 are at the low level, and the output signals of the logic elements 243 to 247 are at the high level. Further, when the voltage V' is higher than VDD $\times$ 4/8 and lower than VDD $\times$ 5/8, the output signals of the logic elements 241 to 243 are at the low level, and the output signals of the logic elements 244 to 247 are at the high level. Further, when the voltage V' is higher than VDD $\times$ 3/8 and lower than VDD $\times$ 4/8, the output signals of the logic elements 241 to 244 are at the low level, and the output signals of the logic elements 245 to 247 are at the high level. Further, when the voltage V' is higher than VDD $\times$ 2/8 and lower than VDD $\times$ 3/8, the output signals of the logic elements 241 to 245 are at the low level, and the output signals of the logic elements 246 and 247 are at the high level. Further, when the voltage V'is higher than VDD $\times$ 1/8, the output signals of the logic elements 241 to 246 are at the low level, and only the output signal of the logic element 247 is at the high level.

The output signals of the logic elements 241 to 247 are signals D1 to D7, respectively. The encoder 250 encodes the signals D1 to D7 into 3-bit data DT [2:0] according to a table in FIG. 9.

As shown in FIG. 9, when the signals D1 to D7 are at the high level, the data DT [2:0] is 011. Further, when the signal D1 is at the low level and the signals D2 to D7 are at the high level, the data DT [2:0] is 010. Further, when the signals D1 and D2 are at the low level and the signals D3 to D7 are at the high level, the data DT [2:0] is 001. Further, when the signals D1 to D3 are at the low level and the signals D4 to D7 are at the high level, the data DT [2:0] is 000. Further, when the signals D1 to D4 are at the low level and the signals D5 to D7 are at the high level, the data DT [2:0] is 100. Further, when the signals D1 to D5 are at the low level and the signals D6 and D7 are at the high level, the data DT [2:0] is 101. Further, when the signals D1 to D6 are at the low level and the signal D7 is at the high level, the data DT [2:0] is 110. Further, when the signals D1 to D7 are at the low level, the data DT [2:0] is 111.

The DT [2] represents a sign of the voltage V', is at the low level when the voltage V' is higher than VDD $\times$ 1/2, and is at the high level when the voltage V' is lower than VDD $\times$ 1/2. The DT [1:0] represents a magnitude of the amplitude of the voltage V', and can take four values including 00, 01, 10, and 11.

The peak time measurement circuit 73 can measure the start time point $t_{start}$ and the end time point $t_{stop}$ of the range including the time at which the potential difference between the output terminal 91 and the output terminal 92 is maximum based on, for example, the 2-bit data DT [1:0].

FIG. 10 is a flowchart showing an example of a procedure for measuring the start time point $t_{start}$ and the end time point $t_{stop}$ by the peak time measurement circuit 73. In the example in FIG. 10, it is assumed that data DT (0) [1:0] to data DT (N - 1) [1:0] that are N pieces of data DT [1:0] are input to the peak time measurement circuit 73.

As shown in FIG. 10, first, in step S1, the peak time measurement circuit 73 initializes a variable i indicating the number of the data DT [1:0] to 0, initializes a variable DT $[1:0]_{max}$ indicating a maximum value of the data DT [1:0] to 00, and initializes both the start time point $t_{start}$ and the end time point $t_{stop}$ to 0.

Next, in step S2, the peak time measurement circuit 73 determines whether the data DT (i) [1:0] is larger than the variable DT $[1:0]_{max}$. When the data DT (i) [1:0] is larger than the variable DT $[1:0]_{max}$ in step S2, the peak time measurement circuit 73 updates the variable DT $[1:0]_{max}$ to the data DT (i) [1:0], and updates both the start time point $t_{start}$ and the end time point $t_{stop}$ to i in step S3.

On the other hand, when the data DT (i) [1:0] is equal to the variable DT $[1:0]_{max}$ in step S2, the peak time measurement circuit 73 determines whether the data DT (i) [1:0] is equal to the variable DT $[1:0]_{max}$ in step S4. When the data DT (i) [1:0] is equal to the variable DT $[1:0]_{max}$ in step S4, the peak time measurement circuit 73 updates the end time point $t_{stop}$ to i in step S5.

Next, in step S6, the peak time measurement circuit 73 determines whether the variable i is smaller than N - 1. When the variable i is smaller than N - 1 in step S6, the peak time measurement circuit 73 updates the variable i to i + 1, and repeats the processing at and after step S2 until the variable i reaches N - 1 in step S7. When the variable i reaches N - 1, the peak time measurement circuit 73 ends the processing.

FIGS. 11 to 13 are diagrams showing an example of the generation of the test signal and the measurement of the start time point $t_{start}$ and the end time point $t_{stop}$ performed by the inspection circuit 110. FIG. 11 shows an example of a case where the impedance characteristics of the sound reproduction device 3 are G1 in FIG. 5. FIG. 12 shows an example of a case where the impedance characteristics of the sound reproduction device 3 are G2 in FIG. 5. FIG. 13 shows an example of a case where the impedance characteristics of the sound reproduction device 3 are G3 in FIG. 5. In the examples in FIGS. 11 to 13, the test signal generation circuit 60 continuously changes the frequency of the test signal in the frequency band of 10 Hz or more and 3 kHz or less while maintaining an amplitude of the test signal at a constant voltage V1.

In the example in FIG. 11, the amplitude of the output voltage V' of the differential low-pass filter 71 is maximum at the peak frequency f0 of the test signal. A maximum value of the data DT [1:0] output by the comparator 72 is 10. The peak time measurement circuit 73 measures the variable i when the data DT [1:0] is 10 initially as the start time point $t_{start}$, and measures the variable i when the data DT [1:0] is 10 finally as the end time point $t_{stop}$.

In the example in FIG. 12, the data DT [1:0] output by the comparator 72 is always 00, and a maximum value thereof is also 00. Therefore, the peak time measurement circuit 73 measures the variable i = 0 when the data DT [1:0] is 10 initially as the start time point $t_{start}$, and measures the variable i = N - 1 when the data DT [1:0] is 10 finally as the end time point $t_{stop}$. The peak frequency detection circuit 70 detects an entire range of the frequency band of 10 Hz or more and 3 kHz or less as the frequency range F0 of the test signal corresponding to a time from the start time point $t_{start}$ to the end time point $t_{stop}$.

In the example in FIG. 13, a maximum value of the data DT [1:0] output by the comparator 72 is 01. The peak time measurement circuit 73 measures the variable i when the data DT [1:0] is 01 initially as the start time point $t_{start}$, and measures the variable i = N - 1 when the data DT [1: 0] is 10 finally as the end time point $t_{stop}$. The peak frequency detection circuit 70 detects the frequency range F0 of the test signal corresponding to the time from the start time point $t_{start}$ to the end time point $t_{stop}$.

When receiving a command for reading the frequency range F0 including the peak frequency f0 from the micro control unit 2, the communication interface circuit 10 acquires the start time point $t_{start}$ and the end time point $t_{stop}$ as the frequency range F0 from the peak frequency detection circuit 70, and transmits the acquired start time point $t_{start}$ and the end time point $t_{stop}$ to the micro control unit 2. Alternatively, the peak frequency detection circuit 70 may calculate the frequency range F0 of the test signal corresponding to the time from the start time point $t_{start}$ to the end time point $t_{stop}$. The communication interface circuit 10 may acquire the frequency range F0 and transmit the acquired frequency range F0 to the micro control unit 2. The micro control unit 2 can acquire the frequency range F0 via the communication interface circuit 10, and determine the presence or absence of the failure and the failure mode of the sound reproduction device 3 based on the frequency range F0. If the lower limit and the upper limit of the frequency range F0 are included in a predetermined range, the micro control unit 2 determines that the sound reproduction device 3 is normal, or determines that the sound reproduction device 3 fails otherwise. Further, when the sound reproduction device 3 fails, the micro control unit 2 determines the failure mode based on the lower limit and the upper limit of the frequency range F0.

For example, in the example in FIG. 11, since the start time point $t_{start}$ corresponding to the lower limit of the frequency range F0 is included in a first reference range, and the end time point $t_{stop}$ corresponding to the upper limit of the frequency range F0 is included in a second reference range, the micro control unit 2 determines that the sound reproduction device 3 is normal. Further, in the example in FIG. 12 or FIG. 13, since the start time point $t_{start}$ corresponding to the lower limit of the frequency range F0 is not included in the first reference range, or the end time point $t_{stop}$ corresponding to the upper limit of the frequency range F0 is not included in the second reference range, the micro control unit 2 can determine that the sound reproduction device 3 fails. Further, in the example in FIG. 12, since the start time point $t_{start}$ is 0 and the end time point $t_{stop}$ is N - 1, the micro control unit 2 can determine a failure mode in which the voltage V' gradually changes even if the test signal changes in the frequency band of 10 Hz or more and 3 kHz or less, that is, a failure mode in which the impedance characteristics are like G2 in FIG. 5, and the magnet of the speaker of the sound reproduction device 3 is broken and removed. Further, in the example in FIG. 13, since the start time point $t_{start}$ is close to N - 1 and the end time point $t_{stop}$ is N - 1, the micro control unit 2 can determine a failure mode in which the peak frequency f0 shifts to a frequency higher than 3 kHz, that is, a failure mode in which the impedance characteristics are like G3 in FIG. 5 and the cone paper of the sound reproduction device 3 is broken.

In the first embodiment, the terminal P1 of the sound reproduction device 3 is an example of a "first terminal", and the terminal P2 of the sound reproduction device 3 is an example of a "second terminal". Further, the output terminal 91 of the semiconductor device 1 is an example of a "first output terminal", and the output terminal 92 of the semiconductor device 1 is an example of a "second output terminal". Further, the pulse-width modulated signal DOP is an example of a "first modulated signal", and the pulse-width modulated signal DON is an example of a "second modulated signal". Further, the pulse-width modulated signal TP is an example of a "third modulated signal", and the pulse-width modulated signal TN is an example of a "fourth modulated signal". Further, the amplified signal DOXP obtained by amplifying the pulse-width modulated signal DOP is an example of a "first amplified signal", and the amplified signal DOXN obtained by amplifying the pulse-width modulated signal DON is an example of a "second amplified signal". Further, the amplified signal DOXP obtained by amplifying the pulse-width modulated signal TP is an example of a "third amplified signal", and the amplified signal DOXN obtained by amplifying the pulse-width modulated signal TN is an example of a "fourth amplified signal". Further, the class-D amplifier 51P is an example of a "first amplifier circuit", and the class-D amplifier 51N is an example of a "second amplifier circuit". Further, the normal operation mode is an example of a "first operation mode", and the inspection mode is an example of a "second operation mode".

The semiconductor device 1 according to the first embodiment has the configuration that can cause one sound reproduction device 3 to output a sound, and may have a configuration that can cause a plurality of sound reproduction devices to output sounds.

As described above, according to the semiconductor device 1 in the first embodiment, in the normal operation mode, the class-D amplifier 51P outputs the amplified signal DOXP obtained by amplifying the pulse-width modulated signal DOP based on the sound source signal DI to the output terminal 91, and the class-D amplifier 51N outputs the amplified signal DOXN obtained by amplifying the pulse-width modulated signal DON based on the sound source signal DI to the output terminal 92, so that the sound reproduction device 3 can reproduce a sound. Specifically, in the normal operation mode, the inverter circuits 201-1 to 201-n provided in the class-D amplifier 51P are coupled in parallel to one another, and the inverter circuits 202-1 to 202-n provided in the class-D amplifier 51N are coupled in parallel to one another. Therefore, the on-resistance $R_{onP}$ of the class-D amplifier 51P and the on-resistance $R_{onN}$ of the class-D amplifier 51N are sufficiently smaller than the impedance $R_{sp}$ of the sound reproduction device 3, and the sound reproduction device 3 can appropriately reproduce a sound.

On the other hand, in the inspection mode, the class-D amplifier 51P outputs the amplified signal DOXP obtained by amplifying the pulse-width modulated signal TP based on the test signal to the output terminal 91, and the class-D amplifier 51N outputs the amplified signal DOXN obtained by amplifying the pulse-width modulated signal TN based on the test signal to the output terminal 92, so that the peak frequency detection circuit 70 can measure the potential difference between the output terminal 91 and the output terminal 92, and detect the frequency range F0 including the peak frequency f0 at which the impedance of the sound reproduction device 3 peaks. Specifically, in the inspection mode, the outputs of some of the inverter circuits 201-1 to 201-n provided in the class-D amplifier 51P have high impedances, and the outputs of some of the inverter circuits 202-1 to 202-n provided in the class-D amplifier 51N have high impedances. Therefore, the on-resistance $R_{onP}$ of the class-D amplifier 51P and the on-resistance $R_{onN}$ of the class-D amplifier 51N increase, and according to Equation (1) described above, an amount of change in the potential difference between the output terminal 91 and the output terminal 92 based on a change in the impedance $R_{sp}$ of the sound reproduction device 3 is large. Particularly, if the on-resistances $R_{onP}$ and $R_{onN}$ are about the same as the impedance $R_{sp}$, a change in the potential difference between the output terminal 91 and the output terminal 92 is the most sensitive to a change in the impedance $R_{sp}$, and therefore the peak frequency detection circuit 70 can accurately detect the frequency range F0 including the peak frequency f0. Therefore, the micro control unit 2 can estimate the impedance characteristics of the sound reproduction device 3, and determine the presence or absence of the failure and the failure mode of the sound reproduction device 3 based on the frequency range F0 including the peak frequency f0.

That is, in the semiconductor device 1 according to the first embodiment, the class-D amplifier 51P and the class-D amplifier 51N are also used for the generation of the amplified signals DOXP and DOXN for causing the sound reproduction device 3 to reproduce a sound in the normal operation mode and the generation of the amplified signals DOXP and DOXN required for detecting the frequency range F0 including the peak frequency f0 in the inspection mode. Further, in the inspection mode, since the amount of the change in the potential difference between the output terminal 91 and the output terminal 92 based on the change in the impedance $R_{sp}$ of the sound reproduction device 3 is large, a size of the peak frequency detection circuit 70 is reduced. Therefore, according to the semiconductor device 1 in the first embodiment, a signal required for detecting a failure of the sound reproduction device 3 can be generated by a small-scale circuit.

According to the semiconductor device 1 in the first embodiment, when the impedance $R_{sp}$ of the sound reproduction device 3 peaks, the potential difference between the output terminal 91 and the output terminal 92 also peaks, and therefore the range including the time at which the potential difference between the output terminal 91 and the output terminal 92 is maximum is measured, so that it is possible to detect the frequency range F0 including the peak frequency f0.

According to the semiconductor device 1 in the first embodiment, in the peak frequency detection circuit 70, the differential low-pass filter 71 reduces the high-frequency noise components overlapped on the amplified signals DOXP and DOXN by modulating the test signal, the comparator 72 converts the output voltage of the differential low-pass filter 71 into the data DT, and the peak time measurement circuit 73 can easily perform high-precision measurement.

According to the semiconductor device 1 in the first embodiment, since the impedance $R_{sp}$ of the sound reproduction device 3 does not depend on magnitudes of voltages of the amplified signals DOXP and DOXN, the sound reproduction device 3 can detect the frequency range F0 including the peak frequency f0 while reproducing a faint sound that cannot be heard by ears of a person in the inspection mode.

## 1-2. Second Embodiment

Hereinafter, for the semiconductor device 1 according to the second embodiment, configurations similar to those of the first embodiment are denoted by the same reference signs, the description similar to that of the first embodiment will be omitted or simplified, and content different from that of the first embodiment will be mainly described.

Since a configuration of the semiconductor device 1 according to the second embodiment is similar to that of FIG. 1, the illustration thereof will be omitted. In the semiconductor device 1 according to the second embodiment, a test signal generated by the test signal generation circuit 60 is different from that of the first embodiment.

In the embodiment, in the inspection mode, the test signal generation circuit 60 generates the modulated signals TP and TN by modulating the test signal in which a frequency is changed in a first frequency band F1 included in a preset frequency band, and then a frequency is changed in a second frequency band F2 other than the first frequency band F1 included in the set frequency band. The first frequency band F1 includes the peak frequency f0 when the sound reproduction device 3 is normal. The first frequency band F1 and the second frequency band F2 may be freely set by the micro control unit 2. Similarly to the first embodiment, the test signal generation circuit 60 pulse-width modulates the test signal to generate the pulse-width modulated signals TP and TN. A pulse-width modulation method applied by the test signal generation circuit 60 is the same as the pulse-width modulation method applied by the pulse-width modulation circuit 33.

Since other configurations and functions of the semiconductor device 1 according to the second embodiment are similar to those of the first embodiment, the description thereof will be omitted.

FIG. 14 is a diagram showing an example of generation of the test signal and measurement of the start time point $t_{start}$ and the end time point $t_{stop}$ performed by the inspection circuit 110 in the second embodiment. FIG. 14 shows an example of a case where impedance characteristics of the sound reproduction device 3 are G1 in FIG. 5. In the example in FIG. 14, the test signal generation circuit 60 changes the frequency of the test signal stepwise by seven types of frequencies included in a frequency band of 10 Hz or more and 3 kHz or less while maintaining an amplitude of the test signal at the constant voltage V1. Specifically, the test signal generation circuit 60 changes the frequency of the test signal stepwise by the four types of frequencies included in the first frequency band F1, and then changes the frequency of the test signal stepwise by the three types of frequencies included in the second frequency band F2 other than the first frequency band F1. In this way, by changing the frequency of the test signal stepwise, circuit scales of the test signal generation circuit 60 and the peak frequency detection circuit 70 can be reduced.

In the example in FIG. 14, an amplitude of the output voltage V' of the differential low-pass filter 71 is maximum at the peak frequency f0 included in the first frequency band F1. A maximum value of the data DT [1:0] output by the comparator 72 is 10. The peak time measurement circuit 73 measures the variable i when the data DT [1:0] is 10 initially as the start time point $t_{start}$, and measures the variable i when the data DT [1:0] is 10 finally as the end time point $t_{stop}$.

The start time point $t_{start}$ and the end time point $t_{stop}$ in the example in FIG. 14 are time points earlier than the start time point $t_{start}$ and the end time point $t_{stop}$ in FIG. 11. That is, the peak frequency detection circuit 70 in the second embodiment can detect the frequency range F0 in a time shorter than that in the first embodiment. In the example in FIG. 14, since the test signal generation circuit 60 changes the frequency of the test signal stepwise, the frequency range F0 includes only the peak frequency f0.

When the peak frequency detection circuit 70 detects the frequency range F0 in the first frequency band F1, the test signal generation circuit 60 and the peak frequency detection circuit 70 may stop operations and output an inspection completion interrupt signal to the micro control unit 2. In that case, the micro control unit 2 can receive the inspection completion interrupt signal, acquire the frequency range F0 via the communication interface circuit 10, and determine presence or absence of a failure and a failure mode of the sound reproduction device 3 based on the frequency range F0.

In the second embodiment, the terminal P1 of the sound reproduction device 3 is an example of the "first terminal", and the terminal P2 of the sound reproduction device 3 is an example of the "second terminal". Further, the output terminal 91 of the semiconductor device 1 is an example of the "first output terminal", and the output terminal 92 of the semiconductor device 1 is an example of the "second output terminal". Further, the pulse-width modulated signal DOP is an example of the "first modulated signal", and the pulse-width modulated signal DON is an example of the "second modulated signal". Further, the pulse-width modulated signal TP is an example of the "third modulated signal", and the pulse-width modulated signal TN is an example of the "fourth modulated signal". Further, the amplified signal DOXP obtained by amplifying the pulse-width modulated signal DOP is an example of the "first amplified signal", and the amplified signal DOXN obtained by amplifying the pulse-width modulated signal DON is an example of the "second amplified signal". Further, the amplified signal DOXP obtained by amplifying the pulse-width modulated signal TP is an example of the "third amplified signal", and the amplified signal DOXN obtained by amplifying the pulse-width modulated signal TN is an example of the "fourth amplified signal". Further, the class-D amplifier 51P is an example of the "first amplifier circuit", and the class-D amplifier 51N is an example of the "second amplifier circuit". Further, the normal operation mode is an example of the "first operation mode", and the inspection mode is an example of the "second operation mode".

The semiconductor device 1 according to the second embodiment has the configuration that can cause one sound reproduction device 3 to output a sound, and may have a configuration that can cause a plurality of sound reproduction devices to output sounds.

According to the semiconductor device 1 in the second embodiment described above, effects similar to those of the semiconductor device 1 according to the first embodiment are achieved. Further, according to the semiconductor device 1 in the second embodiment, since the frequency of the test signal is changed by prioritizing the first frequency band F1 including the peak frequency f0 when the sound reproduction device 3 is normal, the frequency range F0 including the peak frequency f0 can be detected in a short time.

1-3. Third Embodiment

Hereinafter, for the semiconductor device 1 according to the third embodiment, configurations similar to those of the first embodiment or the second embodiment are denoted by the same reference signs, the description similar to that of the first embodiment or the second embodiment will be omitted or simplified, and content different from that of the first embodiment and the second embodiment will be mainly described.

Since a configuration of the semiconductor device 1 according to the third embodiment is similar to that of FIG. 1, the illustration thereof will be omitted. In the semiconductor device 1 according to the third embodiment, a test signal generated by the test signal generation circuit 60 is different from those in the first embodiment and the second embodiment.

In the embodiment, in the inspection mode, the test signal generation circuit 60 generates the modulated signals TP and TN by modulating the test signal in which frequencies are simultaneously changed in the first frequency band F1 and the second frequency band F2. The first frequency band F1 and the second frequency band F2 are different from each other and included in a preset frequency band. The first frequency band F1 may include the peak frequency f0 when the sound reproduction device 3 is normal. The first frequency band F1 and the second frequency band F2 may be freely set by the micro control unit 2. Similarly to the first embodiment, the test signal generation circuit 60 pulse-width modulates the test signal to generate the pulse-width modulated signals TP and TN. A pulse-width modulation method applied by the test signal generation circuit 60 is the same as the pulse-width modulation method applied by the pulse-width modulation circuit 33.

Since other configurations and functions of the semiconductor device 1 according to the third embodiment are similar to those in the first embodiment, the description thereof will be omitted.

FIG. 15 is a diagram showing an example of generation of the test signal and measurement of the start time point $t_{start}$ and the end time point $t_{stop}$ performed by the inspection circuit 110 in the third embodiment. FIG. 15 shows an example of a case where impedance characteristics of the sound reproduction device 3 are G1 in FIG. 5. In the example in FIG. 15, the test signal generation circuit 60 simultaneously changes the frequency of the test signal stepwise in the first frequency band F1 and the second frequency band F2 included in a frequency band of 10 Hz or more and 3 kHz or less while maintaining an amplitude of the test signal at the constant voltage V1. Specifically, the test signal generation circuit 60 changes the frequency of the test signal stepwise by three types of frequencies included in the second frequency band F2 other than the first frequency band F1 in parallel with changing the frequency of the test signal stepwise by four types of frequencies included in the first frequency band F1. In this way, by changing the frequency of the test signal stepwise, circuit scales of the test signal generation circuit 60 and the peak frequency detection circuit 70 can be reduced.

In the example in FIG. 15, an amplitude of the output voltage V' of the differential low-pass filter 71 is maximum at the peak frequency f0 included in the first frequency band F1. A maximum value of the data DT [1:0] output by the comparator 72 is 10. The peak time measurement circuit 73 measures the variable i when the data DT [1:0] is 10 initially as the start time point $t_{start}$, and measures the variable i when the data DT [1:0] is 10 finally as the end time point $t_{stop}$.

The start time point $t_{start}$ and the end time point $t_{stop}$ in the example in FIG. 15 are time points earlier than the start time point $t_{start}$ and the end time point $t_{stop}$ in FIG. 11. That is, regarding the peak frequency detection circuit 70 in the third embodiment, as compared with the first embodiment, a time in which the frequency of the test signal is changed is short, and a detection time of the frequency range F0 is shortened. In the example in FIG. 15, since the test signal generation circuit 60 changes the frequency of the test signal stepwise, the frequency range F0 includes only the peak frequency f0.

The micro control unit 2 can acquire the frequency range F0 via the communication interface circuit 10, and determine the presence or absence of the failure and the failure mode of the sound reproduction device 3 based on the frequency range F0.

In the third embodiment, the terminal P1 of the sound reproduction device 3 is an example of the "first terminal", and the terminal P2 of the sound reproduction device 3 is an example of the "second terminal". Further, the output terminal 91 of the semiconductor device 1 is an example of the "first output terminal", and the output terminal 92 of the semiconductor device 1 is an example of the "second output terminal". Further, the pulse-width modulated signal DOP is an example of the "first modulated signal", and the pulse-width modulated signal DON is an example of the "second modulated signal". Further, the pulse-width modulated signal TP is an example of the "third modulated signal", and the pulse-width modulated signal TN is an example of the "fourth modulated signal". Further, the amplified signal DOXP obtained by amplifying the pulse-width modulated signal DOP is an example of the "first amplified signal", and the amplified signal DOXN obtained by amplifying the pulse-width modulated signal DON is an example of the "second amplified signal". Further, the amplified signal DOXP obtained by amplifying the pulse-width modulated signal TP is an example of the "third amplified signal", and the amplified signal DOXN obtained by amplifying the pulse-width modulated signal TN is an example of the "fourth amplified signal". Further, the class-D amplifier 51P is an example of the "first amplifier circuit", and the class-D amplifier 51N is an example of the "second amplifier circuit". Further, the normal operation mode is an example of the "first operation mode", and the inspection mode is an example of the "second operation mode".

The semiconductor device 1 according to the third embodiment has the configuration that can cause one sound reproduction device 3 to output a sound, and may have a configuration that can cause a plurality of sound reproduction devices to output sounds.

According to the semiconductor device 1 in the third embodiment described above, effects similar to those of the semiconductor device 1 according to the first embodiment or the second embodiment are achieved. Further, according to the semiconductor device 1 in the third embodiment, since the time in which the frequencies of the test signal are changed is shortened by generating the test signal simultaneously having a plurality of frequencies, it is possible to detect the frequency range F0 including the peak frequency f0 in a short time.

1-4. Fourth Embodiment

Hereinafter, for the semiconductor device 1 according to a fourth embodiment, configurations similar to those in any one of the first embodiment to the third embodiment will be denoted by the same reference signs, the description similar to that of any one of the first embodiment to the third embodiment will be omitted or simplified, and contents different from those of the first embodiment to the third embodiment will be mainly described.

FIG. 16 is a diagram showing a configuration example of the semiconductor device 1 according to the fourth embodiment. As shown in FIG. 16, the semiconductor device 1 according to the fourth embodiment is different from the semiconductor device 1 according to the first embodiment shown in FIG. 1 in that an amplifier circuit 50a, a failure detection circuit 120, and six switches 41a, 42a, 43, 44, 121, and 122 are provided.

In response to a control signal output from the failure detection circuit 120, the switch 43 outputs the pulse-width modulated signal DOP to any one of the switches 41 and 41a. Further, in response to a control signal output from the failure detection circuit 120, the switch 44 outputs the pulse-width modulated signal DON to any one of the switches 42 and 42a.

In response to a control signal output from the communication interface circuit 10, the switch 41a outputs any one of a signal from the switch 43 and the pulse-width modulated signal TP to a class-D amplifier 51Pa of the amplifier circuit 50a. Specifically, when the switch 43 outputs the pulse-width modulated signal DOP to the switch 41a, the switch 41a outputs the pulse-width modulated signal DOP to the class-D amplifier 51Pa when an operation mode of the semiconductor device 1 is the normal operation mode. Further, the switch 41a outputs the pulse-width modulated signal TP to the class-D amplifier 51Pa when an operation mode of the semiconductor device 1 is the inspection mode.

In response to a control signal output from the communication interface circuit 10, the switch 42a outputs any one of a signal from the switch 44 and the pulse-width modulated signal TN to a class-D amplifier 51Na of the amplifier circuit 50a. Specifically, when the switch 44 outputs the pulse-width modulated signal DON to the switch 42a, the switch 42a outputs the pulse-width modulated signal DON to the class-D amplifier 51Na when an operation mode of the semiconductor device 1 is the normal operation mode. Further, the switch 42a outputs the pulse-width modulated signal TN to the class-D amplifier 51Na when an operation mode of the semiconductor device 1 is the inspection mode.

When the switches 43 and 44 output the pulse-width modulated signals DOP and DON to the switches 41a and 42a, the amplifier circuit 50a receives the pulse-width modulated signals DOP and DON, and outputs amplified signals DOXPa and DOXNa obtained by amplifying the pulse-width modulated signals DOP and DON to output terminals 93 and 94 of the semiconductor device 1 in the normal operation mode. Further, in the inspection mode, the amplifier circuit 50a receives the pulse-width modulated signals TP and TN, and outputs the amplified signals DOXPa and DOXNa obtained by amplifying the pulse-width modulated signals TP and TN to the output terminals 93 and 94 of the semiconductor device 1.

In the embodiment, the amplifier circuit 50a includes the two class-D amplifiers 51Pa and 51Na. The class-D amplifier 51Pa outputs the amplified signal DOXPa obtained by amplifying the pulse-width modulated signal DOP to the output terminal 93 in the normal operation mode, and outputs the amplified signal DOXPa obtained by amplifying the pulse-width modulated signal TP to the output terminal 93 in the inspection mode. The class-D amplifier 51Na outputs the amplified signal DOXNa obtained by amplifying the pulse-width modulated signal DON to the output terminal 94 in the normal operation mode, and outputs the amplified signal DOXNa obtained by amplifying the pulse-width modulated signal TN to the output terminal 94 in the inspection mode. The output terminal 93 is coupled to a terminal P1a of a sound reproduction device 3a, and the output terminal 94 is coupled to a terminal P2a of the sound reproduction device 3a. The sound reproduction device 3a reproduces a sound having a magnitude corresponding to a voltage difference between the amplified signal DOXP and the amplified signal DOXN.

The failure detection circuit 120 detects a failure of the sound reproduction device 3 based on the frequency range F0 detected by the peak frequency detection circuit 70. Specifically, when a lower limit of the frequency range F0 is included in the first reference range and an upper limit of the frequency range F0 is included in the second reference range, the failure detection circuit 120 determines that the sound reproduction device 3 is normal, or determines that the sound reproduction device 3 fails otherwise. For example, the communication interface circuit 10 may receive a command transmitted from the micro control unit 2, and set the first reference range and the second reference range.

When the failure of the sound reproduction device 3 is detected, the failure detection circuit 120 outputs amplified signals DOXPa and DOXNa obtained by the amplifier circuit 50a amplifying the modulated signals DOP and DON to the sound reproduction device 3a different from the sound reproduction device 3. Specifically, when the failure of the sound reproduction device 3 is detected, the failure detection circuit 120 switches the switch 43 such that the pulse-width modulated signal DOP is output to the class-D amplifier 51Pa of the amplifier circuit 50a, and switches the switch 44 such that the pulse-width modulated signal DON is output to the class-D amplifier 51Na of the amplifier circuit 50a. Accordingly, output of a sound from the sound reproduction device 3 is stopped, the amplified signals DOXP and DOXN obtained by amplifying the pulse-width modulated signals DON and DOP are output to the output terminals 93 and 94, and a sound is output from the sound reproduction device 3a. For example, the sound reproduction device 3a may be a speaker or a buzzer. The sound output from the sound reproduction device 3a may be, for example, a sound obtained by imitating a voice when a person speaks, or various sounds such as a mechanical warning sound or a sound effect.

In response to a control signal output from the failure detection circuit 120, the switch 121 couples one end of the switch 81 to any one of the output terminal 91 and the output terminal 93 of the semiconductor device 1. Further, in response to a control signal output from the failure detection circuit 120, the switch 122 couples one end of the switch 82 to any one of the output terminal 92 and the output terminal 94 of the semiconductor device 1.

In response to a control signal output from the communication interface circuit 10, the switch 81 switches whether to electrically couple or decouple the output terminals 91 and 93 of the semiconductor device 1 and the peak frequency detection circuit 70. The switch 81 electrically decouples the output terminals 91 and 93 from the peak frequency detection circuit 70 when an operation mode of the semiconductor device 1 is the normal operation mode, and electrically couples any one of the output terminals 91 and 93 to the peak frequency detection circuit 70 via the switch 121 when an operation mode of the semiconductor device 1 is the inspection mode.

In response to a control signal output from the communication interface circuit 10, the switch 82 switches whether to electrically couple any one of the output terminals 92 and 94 of the semiconductor device 1 to the peak frequency detection circuit 70, or decouple the output terminals 92 and 94 of the semiconductor device 1 from the peak frequency detection circuit 70. Specifically, the switch 82 electrically decouples the output terminals 92 and 94 from the peak frequency detection circuit 70 when an operation mode of the semiconductor device 1 is the normal operation mode, and electrically couples any one of the output terminals 92 and 94 to the peak frequency detection circuit 70 via the switch 122 when an operation mode of the semiconductor device 1 is the inspection mode.

Until the failure detection circuit 120 detects the failure of the sound reproduction device 3, the peak frequency detection circuit 70 measures a potential difference between the output terminal 91 and the output terminal 92, and detects the frequency range F0 including the peak frequency f0. The peak frequency f0 is a frequency of the test signal at which an impedance of the sound reproduction device 3 peaks in the inspection mode. Further, after the failure detection circuit 120 detects the failure of the sound reproduction device 3, the peak frequency detection circuit 70 measures a potential difference between the output terminal 92 and the output terminal 94, and detects the frequency range F0 including the peak frequency f0. The peak frequency f0 is a frequency of the test signal at which an impedance of the sound reproduction device 3a peaks in the inspection mode.

FIG. 17 is a flowchart showing an example of a procedure of processing performed by the failure detection circuit 120.

As shown in FIG. 17, first, in step S11, the failure detection circuit 120 determines whether the start time point $t_{start}$ measured by the peak time measurement circuit 73 is included in the first reference range of t1 or more and t2 or less. Further, in step S12, the failure detection circuit 120 determines whether the end time point $t_{stop}$ measured by the peak time measurement circuit 73 is included in the second reference range of t3 or more and t4 or less. As described above, for example, the start time point $t_{start}$ corresponds to the lower limit of the frequency range F0, and the end time point $t_{stop}$ corresponds to the upper limit of the frequency range F0.

When the start time point $t_{start}$ is included in the first reference range and the end time point $t_{stop}$ is included in the second reference range, the failure detection circuit 120 controls the switches 43 and 44, and outputs the amplified signals DOXP and DOXN obtained by amplifying the pulse-width modulated signals DOP and DON to the sound reproduction device 3 in step S13. On the other hand, when the start time point $t_{start}$ is not included in the first reference range or the end time point $t_{stop}$ is not included in the second reference range, the failure detection circuit 120 controls the switches 43 and 44, and outputs the amplified signals DOXPa and DOXNa obtained by amplifying the pulse-width modulated signals DOP and DON to the sound reproduction device 3a in step S14.

Since other configurations of the semiconductor device 1 according to the fourth embodiment are similar to those in FIG. 1, the description thereof will be omitted.

In the fourth embodiment, the terminal P1 of the sound reproduction device 3 is an example of the "first terminal", and the terminal P2 of the sound reproduction device 3 is an example of the "second terminal". Further, the output terminal 91 of the semiconductor device 1 is an example of the "first output terminal", and the output terminal 92 of the semiconductor device 1 is an example of the "second output terminal". Further, the pulse-width modulated signal DOP is an example of the "first modulated signal", and the pulse-width modulated signal DON is an example of the "second modulated signal". Further, the pulse-width modulated signal TP is an example of the "third modulated signal", and the pulse-width modulated signal TN is an example of the "fourth modulated signal". Further, the amplified signal DOXP obtained by amplifying the pulse-width modulated signal DOP is an example of the "first amplified signal", and the amplified signal DOXN obtained by amplifying the pulse-width modulated signal DON is an example of the "second amplified signal". Further, the amplified signal DOXP obtained by amplifying the pulse-width modulated signal TP is an example of the "third amplified signal", and the amplified signal DOXN obtained by amplifying the pulse-width modulated signal TN is an example of the "fourth amplified signal". Further, the class-D amplifier 51P is an example of the "first amplifier circuit", and the class-D amplifier 51N is an example of the "second amplifier circuit". Further, the normal operation mode is an example of the "first operation mode", and the inspection mode is an example of the "second operation mode".

The semiconductor device 1 according to the fourth embodiment has the configuration that can cause the two sound reproduction devices 3 and 3a to output sounds, and may have a configuration that can cause three or more sound reproduction devices to output sounds.

According to the semiconductor device 1 in the fourth embodiment described above, effects similar to those of any one of the semiconductor devices 1 according to the first embodiment to the third embodiment are achieved. Further, in the semiconductor device 1 according to the fourth embodiment, the failure detection circuit 120 performs the failure detection of the sound reproduction device 3, and therefore a normal sound can be generated from the sound reproduction device 3a even if the sound reproduction device 3 fails.

1-5. Modification

The present disclosure is not limited to the embodiments, and various modifications can be made within the scope of the invention as defined by the claims.

For example, in the embodiments described above, an example has been given in which, during operation of the system including the semiconductor device 1, the micro control unit 2, and the sound reproduction device 3, the micro control unit 2 determines the presence or absence of the failure of the sound reproduction device 3 based on the frequency range F0 detected by the semiconductor device 1. However, the case where the semiconductor device 1 detects the frequency range F0 is not limited thereto. For example, in an inspection step before the operation of the system, the semiconductor device 1 may transmit the detected frequency range F0 to an inspection device, and the inspection device may inspect whether the sound reproduction device 3 is normal based on the frequency range F0.

For example, in the embodiments described above, the memory 20 in which the sound source data 21-1 to 21-n is stored is incorporated into the semiconductor device 1. Alternatively, instead of using the memory 20, an external memory in which the sound source data 21-1 to 21-n is stored may be coupled to the semiconductor device 1, and the semiconductor device 1 may read the sound source data 21-i that is the sound source signal DI from the external memory. Alternatively, instead of using the memory 20, the micro control unit 2 may incorporate a memory in which the sound source data 21-1 to 21-n is stored, and the micro control unit 2 may read the sound source data 21-i from the memory and transmit the sound source data 21-i to the semiconductor device 1 as the sound source signal DI.

For example, in the embodiments described above, the examples in FIGS. 2 to 4 are given as the modulation method performed by the pulse-width modulation circuit 33. Alternatively, other modulation methods may be used. For example, pulse-width modulation for generating the pulse-width modulated signal DOP may use a method the same as that in FIG. 2, and pulse-width modulation for generating the pulse-width modulated signal DON may use the method shown in FIG. 18. In an example in FIG. 18, the pulse-width modulated signal DON is a signal obtained by inverting a logic level of the pulse-width modulated signal DOP shown in FIG. 2, and the larger the value of the sigma-delta modulated signal DS is, the shorter the high-level time is. For example, when the sigma-delta modulated signal DS is decimal "-7", that is, binary "1001", the pulse-width modulated signal DON is at a low level in the section T1, and is at a high level in the 15 sections T2 to T16. Further, for example, when the sigma-delta modulated signal DS is decimal "0", that is, binary "0000", the pulse-width modulated signal DON is at the low level in the 8 sections T1 to T8, and is at the high level in the 8 sections T9 to T16. Further, for example, when the sigma-delta modulated signal DS is decimal "7", that is, binary "0111", the pulse-width modulated signal DON is at the low level in the 15 sections T1 to T15, and is at the high level in the section T16. Therefore, for example, a difference between the pulse-width modulated signal DOP and the pulse-width modulated signal DON when the sigma-delta modulated signal DS is the decimal "-7", "0", or "7" is as shown in FIG. 19.

2. Electronic Apparatus

FIG. 20 is a functional block diagram showing an example of a configuration of the electronic apparatus according to the embodiment using the semiconductor device 1 according to the embodiments.

As shown in FIG. 20, an electronic apparatus 300 according to the embodiment includes the semiconductor device 1, m sound reproduction devices 3-1 to 3-m, a processing unit 310, an operation unit 320, a storage unit 330, and a display unit 340. The electronic apparatus 300 according to the embodiment may have a configuration in which some elements in FIG. 20 are omitted or changed, or other elements are added.

The processing unit 310 performs control processing and various kinds of data processing of the units of the electronic apparatus 300. For example, the processing unit 310 transmits various commands to the semiconductor device 1, and controls an operation of the semiconductor device 1. Further, the processing unit 310 performs various kinds of processing in response to an operation signal from the operation unit 320, processing of transmitting a display signal for displaying various kinds of information on the display unit 340, and the like. For example, the processing unit 310 may be the micro control unit 2 described above.

The operation unit 320 is an input device implemented by operation keys, button switches, and the like, and outputs an operation signal in response to an operation performed by a user to the processing unit 310.

The storage unit 330 stores programs, data, and the like for performing various kinds of calculation processing and control processing by the processing unit 310. The storage unit 330 is implemented by, for example, a hard disk, a flexible disk, an MO, an MT, various memories, a CD-ROM, or a DVD-ROM.

The display unit 340 is a display device implemented by an LCD or the like, and displays various kinds of information based on an input display signal. The LCD is an abbreviation for a liquid crystal display. A touch panel that functions as the operation unit 320 may be provided in the display unit 340.

Based on various commands transmitted from the processing unit 310, the semiconductor device 1 generates a sound signal and outputs the sound signal to the sound reproduction device 3-1. The sound reproduction device 3-1 corresponds to the sound reproduction device 3 described above. Further, the semiconductor device 1 may inspect the sound reproduction device 3-1 and transmit an inspection result to the processing unit 310. The processing unit 310 may determine presence or absence of a failure and a failure mode of the sound reproduction device 3-1. When the sound reproduction device 3-1 fails, for example, the processing unit 310 may cause any one of the sound reproduction devices 3-2 to 3-m to reproduce a sound for notifying that the sound reproduction device 3-1 fails, or switch an output destination of the sound signal from the sound reproduction device 3-1 to any one of the sound reproduction devices 3-2 to 3-m. Alternatively, when the failure of the sound reproduction device 3-1 is detected, the semiconductor device 1 may switch the output destination of the sound signal from the sound reproduction device 3-1 to the sound reproduction device 3-2. The sound reproduction device 3-2 corresponds to the sound reproduction device 3a described above.

Since the semiconductor device 1 can generate the signal required for detecting the failure of the sound reproduction device 3-1, it is possible to implement the highly reliable electronic apparatus 300.

As such an electronic apparatus 300, various electronic apparatuses are considered, and examples thereof include: various household electrical appliances such as a warning device, a rice cooker, an IH cooking heater, a vacuum cleaner, and a washing machine, an electronic timepiece, a personal computer such as a mobile computer, a laptop computer, or a tablet computer, a mobile terminal such as a smartphone or a mobile phone, a digital camera, an inkjet ejection device such as an inkjet printer, a storage area network apparatus such as a router or a switch, a local area network apparatus, a mobile terminal base station apparatus, a television, a video camera, a video recorder, a car navigation device, a real-time clock device, a pager, an electronic notebook, an electronic dictionary, a calculator, an electronic game apparatus, a game controller, a word processor, a workstation, a videophone, a crime prevention television monitor, electronic binoculars, a POS terminal, a medical apparatus such as an electronic clinical thermometer, a sphygmomanometer, a blood glucose meter, an electrocardiogram measurement device, an ultrasonic diagnostic device, or an electronic endoscope, a fish finder, various measurement apparatuses, meters of a vehicle, an aircraft, a ship, or the like, a flight simulator, a head mounted display, a motion trace, a motion tracking, a motion controller, and a pedestrian self-navigating device.

FIG. 21 is a diagram showing a configuration example of a warning device 300A that is an example of the electronic apparatus 300. In FIG. 21, elements the same as those in FIG. 20 are denoted by the same reference signs. The warning device 300A shown in FIG. 21 is mounted on a vehicle 400. The sound reproduction device 3-1 is a speaker, and the sound reproduction devices 3-2 to 3-5 are buzzers.

The processing unit 310 transmits reproduction commands or the like of various sounds to the semiconductor device 1 based on signals from various sensors (not shown). Examples of the various sounds include: a sound or a warning sound imitating a voice of a person for notifying an abnormality of a brake, engine oil, power steering, a brake override system, or the like, traveling with an ajar door, unsteady traveling, traveling without releasing a parking brake, not wearing a seatbelt, approaching a preceding vehicle, and the like, a sound effect for notifying a blinker, a hazard, backing, and the like.

Based on a command from the processing unit 310, the semiconductor device 1 generates a sound signal based on some of a plurality of pieces of sound source data corresponding to the various sounds, and outputs the generated sound signal to the sound reproduction device 3-1. Further, the semiconductor device 1 may inspect the sound reproduction device 3-1 and transmit an inspection result to the processing unit 310. The processing unit 310 may determine the presence or absence of the failure and the failure mode of the sound reproduction device 3-1. When the sound reproduction device 3-1 fails, for example, the processing unit 310 may cause any one of the sound reproduction devices 3-2 to 3-5 to reproduce a sound for notifying that the sound reproduction device 3-1 fails, or switch an output destination of the sound signal from the sound reproduction device 3-1 to any one of the sound reproduction devices 3-2 to 3-5. Alternatively, when the failure of the sound reproduction device 3-1 is detected, the semiconductor device 1 may switch an output destination of the sound signal from the sound reproduction device 3-1 to the sound reproduction device 3-2.

Since the semiconductor device 1 can generate the signal required for detecting the failure of the sound reproduction device 3-1, it is possible to implement the highly reliable warning device 300A.

The present disclosure is not limited to the embodiment, and various modifications can be made within the scope of the invention as defined by the claims.

The embodiments and the modifications described above are examples, and are not limited thereto. For example, the embodiments and the modifications can be combined as appropriate.

The present disclosure includes a configuration substantially the same as the configurations described in the embodiments, for example, a configuration having the same function, method, and result, or a configuration having the same object and effects. Further, the present disclosure includes a configuration obtained by replacing a non-essential part of the configurations described in the embodiments. Further, the present disclosure includes a configuration that achieves operations and effects the same as those of the configurations described in the embodiments, or a configuration that can achieve the same object. Further, the present disclosure includes a configuration obtained by adding a well-known technique to the configurations described in the embodiments.

The following content is derived from the embodiments and the modifications described above.

A semiconductor device according to an aspect includes:

a first output terminal coupled to a first terminal of a sound reproduction device;
a second output terminal coupled to a second terminal of the sound reproduction device;
a modulation circuit configured to modulate a signal based on a sound source signal to output a first modulated signal and a second modulated signal;
a first amplifier circuit configured to output a first amplified signal obtained by amplifying the first modulated signal to the first output terminal in a first operation mode;
a second amplifier circuit configured to output a second amplified signal obtained by amplifying the second modulated signal to the second output terminal in the first operation mode;
a test signal generation circuit configured to modulate a test signal in which a frequency is changed in a preset frequency band to generate a third modulated signal and a fourth modulated signal in a second operation mode; and
a peak frequency detection circuit configured to measure a potential difference between the first output terminal and the second output terminal, and detect a frequency range including a peak frequency that is the frequency of the test signal at which an impedance of the sound reproduction device peaks in the second operation mode, in which
the first amplifier circuit outputs a third amplified signal obtained by amplifying the third modulated signal to the first output terminal in the second operation mode,
the second amplifier circuit outputs a fourth amplified signal obtained by amplifying the fourth modulated signal to the second output terminal in the second operation mode,
the first amplifier circuit includes a plurality of inverter circuits each having an output terminal coupled to the first output terminal,
the second amplifier circuit includes a plurality of inverter circuits each having an output terminal coupled to the second output terminal,
in the first operation mode, the first modulated signal is input to input terminals of the plurality of inverter circuits provided in the first amplifier circuit, and the second modulated signal is input to input terminals of the plurality of inverter circuits provided in the second amplifier circuit, and
in the second operation mode, the third modulated signal is input to input terminals of some of the plurality of inverter circuits provided in the first amplifier circuit, output terminals of other inverter circuits among the plurality of inverter circuits provided in the first amplifier circuit have high impedances, the fourth modulated signal is input to input terminals of some of the plurality of inverter circuits provided in the second amplifier circuit, and output terminals of other inverter circuits among the plurality of inverter circuits provided in the second amplifier circuit have high impedances.

According to the semiconductor device, in the first operation mode, the first amplifier circuit outputs the first amplified signal obtained by amplifying the first modulated signal based on the sound source signal to the first output terminal, and the second amplifier circuit outputs the second amplified signal obtained by amplifying the second modulated signal based on the sound source signal to the second output terminal, so that the sound reproduction device can reproduce a sound. Specifically, in the first operation mode, the plurality of inverter circuits provided in the first amplifier circuit are coupled in parallel to one another, and the plurality of inverter circuits provided in the second amplifier circuit are coupled in parallel to one another. Therefore, an on-resistance of the first amplifier circuit and an on-resistance of the second amplifier circuit are sufficiently smaller than an impedance of the sound reproduction device, and the sound reproduction device can appropriately reproduce a sound.

On the other hand, in the second operation mode, the first amplifier circuit outputs the third amplified signal obtained by amplifying the third modulated signal based on the test signal to the first output terminal, and the second amplifier circuit outputs the fourth amplified signal obtained by amplifying the fourth modulated signal based on the test signal to the second output terminal, so that the peak frequency detection circuit can measure the potential difference between the first output terminal and the second output terminal, and detect the frequency range including the peak frequency at which the impedance of the sound reproduction device peaks. Specifically, in the second operation mode, outputs of some of the plurality of inverter circuits provided in the first amplifier circuit have the high impedances, and outputs of some of the plurality of inverter circuits provided in the second amplifier circuit have the high impedances. Therefore, the on-resistance of the first amplifier circuit and the on-resistance of the second amplifier circuit increase, and an amount of a change in the potential difference between the first output terminal and the second output terminal based on a change in the impedance of the sound reproduction device is large, so that the peak frequency detection circuit can accurately detect the frequency range including the peak frequency. Therefore, for example, an external device can estimate impedance characteristics of the sound reproduction device based on the frequency range including the peak frequency, and determine presence or absence of a failure and a failure mode of the sound reproduction device.

That is, in the semiconductor device, the first amplifier circuit and the second amplifier circuit are also used for the generation of the first amplified signal and the second amplified signal for causing the sound reproduction device to reproduce a sound in the first operation mode, and the generation of the third amplified signal and the fourth amplified signal that are required for detecting the frequency range including the peak frequency in the second operation mode. Further, in the second operation mode, since the amount of the change in the potential difference between the first output terminal and the second output terminal based on the change in the impedance of the sound reproduction device is large, a size of the peak frequency detection circuit is reduced. Therefore, according to the semiconductor device, a signal required for detecting the failure of the sound reproduction device can be generated by a small-scale circuit.

In the semiconductor device according to the aspect,
in the second operation mode, the peak frequency detection circuit may detect the frequency range by measuring a range including a time at which the potential difference between the first output terminal and the second output terminal is maximum.

According to the semiconductor device, since the potential difference between the first output terminal and the second output terminal also peaks when the impedance of the sound reproduction device peaks, by measuring the range including the time at which the potential difference between the first output terminal and the second output terminal is maximum, it is possible to detect the frequency range including the peak frequency.

In the semiconductor device according to the aspect,
the peak frequency detection circuit may include

a differential low-pass filter to which a voltage of the first output terminal and a voltage of the second output terminal are input,
a comparator configured to compare an output voltage of the differential low-pass filter with at least one threshold voltage, and
a peak time measurement circuit configured to measure, based on an output signal of the comparator, the range including the time at which the potential difference between the first output terminal and the second output terminal is maximum.

According to the semiconductor device, the differential low-pass filter can reduce high-frequency noise components overlapped on the third amplified signal and the fourth amplified signal by modulating the test signal, the comparator can convert the output voltage of the differential low-pass filter into a digital value, and the peak time measurement circuit can easily perform high-precision measurement.

In the semiconductor device according to the aspect,
a cutoff frequency of the differential low-pass filter may be higher than a maximum frequency of the frequency band.

According to the semiconductor device, since the cutoff frequency of the differential low-pass filter is higher than the maximum frequency of the frequency band in which the frequency of the test signal is changed, the differential low-pass filter does not attenuate frequency components included in the frequency band, and the peak time measurement circuit can perform the high-precision measurement.

In the semiconductor device according to the aspect,

in the second operation mode, the test signal generation circuit may generate the third modulated signal and the fourth modulated signal by modulating the test signal in which a frequency is changed in a first frequency band included in the frequency band, and then a frequency is changed in a second frequency band other than the first frequency band included in the frequency band, and

the first frequency band may include the peak frequency when the sound reproduction device is normal.

According to the semiconductor device, since the frequency of the test signal is changed by prioritizing the first frequency band including the peak frequency when the sound reproduction device is normal, the frequency range including the peak frequency can be detected in a short time.

In the semiconductor device according to the aspect,

in the second operation mode, the test signal generation circuit may generate the third modulated signal and the fourth modulated signal by modulating the test signal in which frequencies are simultaneously changed in a first frequency band and a second frequency band, the first frequency band and the second frequency band being different from each other and included in the frequency band.

According to the semiconductor device, since a time in which the frequencies of the test signal are changed is shortened by generating the test signal simultaneously having a plurality of frequencies, it is possible to detect the frequency range including the peak frequency in a short time.

The semiconductor device according to the aspect may further include:

a failure detection circuit configured to detect a failure of the sound reproduction device based on the frequency range detected by the peak frequency detection circuit, in which

when the failure of the sound reproduction device is detected, the failure detection circuit may output a signal obtained by amplifying the first modulated signal and a signal obtained by amplifying the second modulated signal to a sound reproduction device different from the sound reproduction device.

According to the semiconductor device, even if the sound reproduction device fails, a normal sound can be generated from another sound reproduction device.

An electronic apparatus according to an aspect includes:

the semiconductor device according to the aspect; and

the sound reproduction device.

According to the electronic apparatus, since the semiconductor device that can generate a signal required for detecting a failure of the sound reproduction device is provided, reliability can be improved.

## Claims

**1.** A semiconductor device (1) comprising:

a first output terminal (91) suitable for being coupled to a first terminal (P1) of a sound reproduction device (3) ;

a second output terminal (92) suitable for being coupled to a second terminal (P2) of the sound reproduction device (3) ;

a modulation circuit (30) configured to modulate a signal based on a sound source signal (DI) to output a first modulated signal (DOP) and a second modulated signal (DON) ;

a first amplifier circuit (51P) configured to output a first amplified signal (DOXP) obtained by amplifying the first modulated signal (DOP) to the first output terminal (91) in a first operation mode;

a second amplifier circuit (51N) configured to output a second amplified signal (DOXN) obtained by amplifying the second modulated signal (DON) to the second output terminal (92) in the first operation mode;

a test signal generation circuit (60) configured to modulate a test signal in which a frequency is changed in a preset frequency band to generate a third modulated signal (TP) and a fourth modulated signal (TN) in a second operation mode; and

a peak frequency detection circuit (70) configured to measure a potential difference between the first output terminal (91) and the second output terminal (92), and detect a frequency range (F0) including a peak frequency that is the frequency of the test signal at which an impedance of the sound reproduction device peaks in the second operation mode, wherein

the first amplifier circuit (51P) outputs a third amplified signal (DOXP) obtained by amplifying the third modulated signal (TP) to the first output terminal in the second operation mode,

the second amplifier circuit (51N) outputs a fourth amplified signal (DOXN) obtained by amplifying the fourth modulated signal (TN) to the second output terminal (92) in the second operation mode,

**characterised in that**

the first amplifier circuit (51P) includes a plurality of inverter circuits (201-1,..., 201-n) each having an output terminal coupled to the first output terminal (91),
the second amplifier circuit (51N) includes a plurality of inverter circuits (202-1,..., 202-n) each having an output terminal coupled to the second output terminal (92),
in the first operation mode, the first modulated signal (DOP) is input to input terminals of the plurality of inverter circuits (201-1,..., 201-n) provided in the first amplifier circuit (51P), and the second modulated signal (DON) is input to input terminals of the plurality of inverter circuits (202-1,...,202-n) provided in the second amplifier circuit (51N), and
in the second operation mode, the third modulated signal (TP) is input to input terminals of some of the plurality of inverter circuits (201-1,..., 201-n) provided in the first amplifier circuit (51P), output terminals of other inverter circuits among the plurality of inverter circuits (201-1,..., 201-n) provided in the first amplifier circuit (51P) have high impedances, the fourth modulated signal (TN) is input to input terminals of some of the plurality of inverter circuits (202-1,..., 202-n) provided in the second amplifier circuit (51N) and output terminals of other inverter circuits among the plurality of inverter circuits (202-1,..., 202-n) provided in the second amplifier circuit (51N) have high impedances.

**2.** The semiconductor device according to claim 1, wherein
in the second operation mode, the peak frequency detection circuit detects the frequency range by measuring a range including a time at which the potential difference between the first output terminal and the second output terminal is maximum.

**3.** The semiconductor device according to claim 2, wherein
the peak frequency detection circuit includes

a differential low-pass filter to which a voltage of the first output terminal and a voltage of the second output terminal are input,
a comparator configured to compare an output voltage of the differential low-pass filter with at least one threshold voltage, and
a peak time measurement circuit configured to measure, based on an output signal of the comparator, the range including the time at which the potential difference between the first output terminal and the second output terminal is maximum.

**4.** The semiconductor device according to claim 3, wherein
a cutoff frequency of the differential low-pass filter is higher than a maximum frequency of the frequency band.

**5.** The semiconductor device according to claim 1, wherein

in the second operation mode, the test signal generation circuit generates the third modulated signal and the fourth modulated signal by modulating the test signal in which a frequency is changed in a first frequency band included in the frequency band, and then a frequency is changed in a second frequency band other than the first frequency band included in the frequency band, and
the first frequency band includes the peak frequency when the sound reproduction device is normal.

**6.** The semiconductor device according to claim 1, wherein
in the second operation mode, the test signal generation circuit generates the third modulated signal and the fourth modulated signal by modulating the test signal in which frequencies are simultaneously changed in a first frequency band and a second frequency band, the first frequency band and the second frequency band being different from each other and included in the frequency band.

**7.** The semiconductor device according to claim 1, further comprising:

a failure detection circuit configured to detect a failure of the sound reproduction device based on the frequency range detected by the peak frequency detection circuit, wherein
when the failure of the sound reproduction device is detected, the failure detection circuit outputs a signal obtained by amplifying the first modulated signal and a signal obtained by amplifying the second modulated signal to a sound reproduction device different from the sound reproduction device.

**8.** An electronic apparatus comprising:

the semiconductor device according to claim 1; and
the sound reproduction device.

## Patentansprüche

1. Halbleiterbauelement (1), umfassend:

einen ersten Ausgabeanschluss (91), der geeignet ist, an einen ersten Anschluss (P1) einer Tonwiedergabeeinrichtung (3) gekoppelt zu werden;
einen zweiten Ausgabeanschluss (92), der geeignet ist, an einen zweiten Anschluss (P2) der Tonwiedergabeeinrichtung (3) gekoppelt zu werden;
einen Modulationsschaltkreis (30), der eingerichtet ist, ein Signal basierend auf einem Tonquellensignal (DI) zu modulieren um ein erstes moduliertes Signal (DOP) und ein zweites moduliertes Signal (DON) auszugeben;
einen ersten Verstärkungsschaltkreis (51P), der eingerichtet ist, ein erstes verstärktes Signal (DOXP), das durch Verstärken des ersten modulierten Signals (DOP) erhalten wird, an den ersten Ausgabeanschluss (91) in einem ersten Betriebsmodus auszugeben;
einen zweiten Verstärkungsschaltkreis (51N), der eingerichtet ist, ein zweites verstärktes Signal (DOXN), das durch Verstärken des zweiten modulierten Signals (DON) erhalten wird, an den zweiten Ausgabeanschluss (92) in dem ersten Betriebsmodus auszugeben;
eine Testsignalerzeugungsschaltung (60), die eingerichtet ist, ein Testsignal, in dem eine Frequenz in einem voreingestellten Frequenzband geändert wird, zu modulieren, um ein drittes moduliertes Signal (TP) und ein viertes moduliertes Signal (TN) in einem zweiten Betriebsmodus zu erzeugen; und
einen Spitzenfrequenzdetektionsschaltkreis (70), der eingerichtet ist, eine Potentialdifferenz zwischen dem ersten Ausgabeanschluss (91) und dem zweiten Ausgabeanschluss (92) zu messen und einen Frequenzbereich (F0) zu detektieren, der eine Spitzenfrequenz enthält, die die Frequenz des Testsignals ist, bei der eine Impedanz der Tonwiedergabeeinrichtung in dem zweiten Betriebsmodus einen Spitzenwert erreicht, wobei
der erste Verstärkungsschaltkreis (51P) ein drittes verstärktes Signal (DOXP), das durch Verstärken des dritten modulierten Signals (TP) erhalten wird, an den ersten Ausgabeanschluss in dem zweiten Betriebsmodus ausgibt,
der zweite Verstärkungsschaltkreis (51N) ein viertes verstärktes Signal (DOXN), das durch Verstärken des vierten modulierten Signals (TN) erhalten wird, an den zweiten Ausgabeanschluss (92) in dem zweiten Betriebsmodus ausgibt,
**dadurch gekennzeichnet, dass**
der erste Verstärkungsschaltkreis (51P) eine Vielzahl von Umrichterschaltkreisen (201-1,..., 201-n) enthält, die jeweils einen Ausgabeanschluss aufweisen, der an den ersten Ausgabeanschluss (91) gekoppelt ist,
der zweite Verstärkungsschaltkreis (51N) eine Vielzahl von Umrichterschaltkreisen (202-1,..., 202-n) enthält, die jeweils einen Ausgabeanschluss aufweisen, der an den zweiten Ausgabeanschluss (92) gekoppelt ist,
in dem ersten Betriebsmodus das erste modulierte Signal (DOP) in Eingangsanschlüsse der Vielzahl von Umrichterschaltkreisen (201-1,..., 201-n) eingegeben wird, die in dem ersten Verstärkungsschaltkreis (51P) bereitgestellt sind, und das zweite modulierte Signal (DON) in Eingangsanschlüsse der Vielzahl von Umrichterschaltkreisen (202-1,..., 202-n) eingegeben wird, die in dem zweiten Verstärkungsschaltkreis (51N) bereitgestellt sind, und
in dem zweiten Betriebsmodus das dritte modulierte Signal (TP) in Eingangsanschlüsse einiger der Vielzahl von Umrichterschaltkreisen (201-1,..., 201-n) eingegeben wird, die in dem ersten Verstärkungsschaltkreis (51P) bereitgestellt sind, wobei Ausgabeanschlüsse von anderen Umrichterschaltkreisen aus der Vielzahl von Umrichterschaltkreisen (201-1,..., 201-n), die in dem ersten Verstärkungsschaltkreis (51P) bereitgestellt sind, hohe Impedanzen haben, das vierte modulierte Signal (TN) in Eingangsanschlüsse einiger der Vielzahl von Umrichterschaltkreisen (202-1,..., 202-n) eingegeben wird, die in dem zweiten Verstärkungsschaltkreis (51N) bereitgestellt sind, und Ausgabeanschlüsse von anderen Umrichterschaltkreisen aus der Vielzahl von Umrichterschaltkreisen (202-1,..., 202-n), die in dem zweiten Verstärkungsschaltkreis (51N) bereitgestellt sind, hohe Impedanzen haben.

2. Halbleiterbauelement nach Anspruch 1, wobei
in dem zweiten Betriebsmodus der Spitzenfrequenzdetektionsschaltkreis den Frequenzbereich durch Messen eines Bereichs detektiert, der einen Zeitpunkt enthält, zu dem die Potentialdifferenz zwischen dem ersten Ausgabeanschluss und dem zweiten Ausgabeanschluss maximal ist.

3. Halbleiterbauelement nach Anspruch 2, wobei

der Spitzenfrequenzdetektionsschaltkreis enthält
ein Differentialtiefpassfilter, in das eine Spannung des ersten Ausgabeanschlusses und eine Spannung des zweiten Ausgabeanschlusses eingegeben werden,
einen Komparator, der eingerichtet ist, eine Ausgangsspannung des Differentialtiefpassfilters mit mindestens einer Schwellenspannung zu vergleichen, und
einen Spitzenzeitmessschaltkreis, der eingerichtet ist, basierend auf einem Ausgangssignal des Komparators den Bereich zu messen, der den Zeitpunkt enthält, zu dem die Potentialdifferenz zwischen dem ersten Ausgabeanschluss und dem zweiten Ausgabeanschluss maximal ist.

4. Halbleiterbauelement nach Anspruch 3, wobei
eine Grenzfrequenz des Differentialtiefpassfilters höher ist als eine maximal Frequenz des Frequenzbands.

5. Halbleiterbauelement nach Anspruch 1, wobei

in dem zweiten Betriebsmodus der Testsignalerzeugungsschaltkreis das dritte modulierte Signal und das vierte modulierte Signal durch Modulieren des Testsignals erzeugt, in dem eine Frequenz in einem ersten Frequenzband geändert wird, das in dem Frequenzband enthalten ist, und dann eine Frequenz in einem zweiten Frequenzband geändert wird, das nicht das erste Frequenzband ist, das in dem Frequenzband enthalten ist, und das erste Frequenzband die Spitzenfrequenz enthält, wenn die Tonwiedergabeeinrichtung normal ist.

6. Halbleiterbauelement nach Anspruch 1, wobei
in dem zweiten Betriebsmodus der Testsignalerzeugungsschaltkreis das dritte modulierte Signal und das vierte modulierte Signal durch Modulieren des Testsignals erzeugt, in dem Frequenzen gleichzeitig in einem ersten Frequenzband und in einem zweiten Frequenzband geändert werden, wobei sich das erste Frequenzband und das zweite Frequenzband voneinander unterscheiden und in dem Frequenzband enthalten sind.

7. Halbleiterbauelement nach Anspruch 1, weiter umfassend:

einen Fehlerdetektionsschaltkreis, um einen Fehler der Tonwiedergabeeinrichtung basierend auf dem Frequenzbereich zu detektieren, der von dem Spitzenfrequenzdetektionsschaltkreis detektiert wird, wobei
wenn der Fehler der Tonwiedergabeeinrichtung detektiert wird, der Fehlerdetektionsschaltkreis ein Signal, das durch Verstärken des ersten modulierten Signals erhalten wird, und ein Signal, das durch Verstärken des zweiten modulierten Signals erhalten wird, an eine Tonwiedergabeeinrichtung ausgibt, die sich von der Tonwiedergabeeinrichtung unterscheidet.

8. Elektronische Vorrichtung, umfassend:

das Halbleiterbauelement nach Anspruch 1; und
die Tonwiedergabeeinrichtung.

## Revendications

1. Dispositif à semi-conducteur (1) comprenant :

une première borne de sortie (91) adaptée pour être accouplée à une première borne (P1) d’un dispositif de reproduction sonore (3) ;
une deuxième borne de sortie (92) adaptée pour être accouplée à une deuxième borne (P2) du dispositif de reproduction sonore (3) ;
un circuit de modulation (30) configuré pour moduler un signal sur la base d’un signal source sonore (DI) pour émettre un premier signal modulé (DOP) et un deuxième signal modulé (DON) ;
un premier circuit amplificateur (51P) configuré pour envoyer un premier signal amplifié (DOXP) obtenu par amplification du premier signal modulé (DOP) à la première borne de sortie (91) dans un premier mode de fonctionnement ;
un deuxième circuit amplificateur (51N) configuré pour envoyer un deuxième signal amplifié (DOXN) obtenu par amplification du deuxième signal modulé (DON) à la deuxième borne de sortie (92) dans le premier mode de fonctionnement ;
un circuit de génération de signal de test (60) configuré pour moduler un signal de test dans lequel une fréquence est modifiée dans une bande de fréquence prédéfinie pour générer un troisième signal modulé (TP) et un quatrième signal modulé (TN) dans un deuxième mode de fonctionnement ; et
un circuit de détection de fréquence de crête (70) configuré pour mesurer une différence de potentiel entre la première borne de sortie (91) et la deuxième borne de sortie (92), et pour détecter une plage de fréquence (F0) incluant une fréquence de crête, laquelle est la fréquence du signal de test à laquelle une impédance du dispositif de reproduction sonore atteint son maximum dans le deuxième mode de fonctionnement, dans lequel
le premier circuit amplificateur (51P) envoie un troisième signal amplifié (DOXP) obtenu par amplification du troisième signal modulé (TP) à la première borne de sortie dans le deuxième mode de fonctionnement,
le deuxième circuit amplificateur (51N) envoie un quatrième signal amplifié (DOXN) obtenu par amplification du quatrième signal modulé (TN) à la deuxième borne de sortie (92) dans le deuxième mode de fonctionnement,
**caractérisé en ce que**
le premier circuit amplificateur (51P) inclut une pluralité de circuits inverseurs (201-1, ..., 201-n) comportant respectivement une borne de sortie accouplée à la première borne de sortie (91),
le deuxième circuit amplificateur (51N) inclut une pluralité de circuits inverseurs (202-1, ..., 202-n) comportant respectivement une borne de sortie accouplée à la deuxième borne de sortie (92),
dans le premier mode de fonctionnement, le premier signal modulé (DOP) est entré dans des bornes d'entrée de la pluralité de circuits inverseurs (201-1, ..., 201-n) prévus dans le premier circuit amplificateur (51P), et le deuxième signal modulé (DON) est entré dans des bornes d'entrée de la pluralité de circuits inverseurs (202-1, ..., 202-n) prévus dans le deuxième circuit amplificateur (51N), et
dans le deuxième mode de fonctionnement, le troisième signal modulé (TP) est entré dans des bornes d'entrée de certains parmi la pluralité de circuits inverseurs (201-1, ..., 201-n) prévus dans le premier circuit amplificateur (51P), des bornes de sortie d'autres circuits inverseurs parmi la pluralité de circuits inverseurs (201-1, ..., 201-n) prévus dans le premier circuit amplificateur (51P) présentent des impédances élevées, le quatrième signal modulé (TN) est entré dans des bornes d'entrée de certains parmi la pluralité de circuits inverseurs (202-1, ..., 202-n) prévus dans le deuxième circuit amplificateur (51N), et des bornes de sortie d'autres circuits inverseurs parmi la pluralité de circuits inverseurs (202-1, ..., 202-n) prévus dans le deuxième circuit amplificateur (51N) présentent des impédances élevées.

**2.** Dispositif à semi-conducteur selon la revendication 1, dans lequel
dans le deuxième mode de fonctionnement, le circuit de détection de fréquence de crête détecte la plage de fréquence en mesurant une plage incluant un moment auquel la différence de potentiel entre la première borne de sortie et la deuxième borne de sortie est à son maximum.

**3.** Dispositif à semi-conducteur selon la revendication 2, dans lequel

le circuit de détection de fréquence de crête inclut un filtre passe-bas différentiel auquel une tension de la première borne de sortie et une tension de la deuxième borne de sortie sont fournies,
un comparateur configuré pour comparer une tension de sortie du filtre passe-bas différentiel avec au moins une tension seuil, et
un circuit de mesure de moment de crête configuré pluralité d'ouvertures de retenue de récipient mesurer, sur la base d'un signal de sortie du comparateur, la plage incluant le moment auquel la différence de potentiel entre la première borne de sortie et la deuxième borne de sortie est à son maximum.

**4.** Dispositif à semi-conducteur selon la revendication 3, dans lequel
une fréquence de coupure du filtre passe-bas différentiel est plus élevée qu'une fréquence maximale de la bande de fréquence.

**5.** Dispositif à semi-conducteur selon la revendication 1, dans lequel

dans le deuxième mode de fonctionnement, le circuit de génération de signal de test génère le troisième signal modulé et le quatrième signal modulé en modulant le signal de test dans lequel une fréquence est modifiée dans une première bande de fréquence incluse dans la bande de fréquence, et ensuite une fréquence est modifiée dans une deuxième bande de fréquence différente de la première bande de fréquence incluse dans la bande de fréquence, et
la première bande de fréquence inclut la fréquence de crête lorsque le dispositif de reproduction sonore est normal.

**6.** Dispositif à semi-conducteur selon la revendication 1, dans lequel
dans le deuxième mode de fonctionnement, le circuit de génération de signal de test génère le troisième signal modulé et le quatrième signal modulé en modulant le signal de test dans lequel des fréquences sont modifiées simultanément dans une première bande de fréquence et une deuxième bande de fréquence, la première bande de fréquence et la deuxième bande de fréquence étant différentes l'une de l'autre et incluses dans la bande de fréquence.

**7.** Dispositif à semi-conducteur selon la revendication 1, comprenant en outre :

un circuit de détection de panne configuré pour détecter une panne du dispositif de reproduction sonore sur la base de la plage de fréquence détectée par le circuit de détection de fréquence de crête, dans lequel
lorsque la panne du dispositif de reproduction sonore est détectée, le circuit de détection de panne envoie un signal obtenu par amplification du premier signal modulé et un signal obtenu par amplification du deuxième signal modulé à un dispositif de reproduction sonore différent du dispositif de reproduction sonore.

**8.** Appareil électronique comprenant :

le dispositif à semi-conducteur selon la revendication 1 ; et
le dispositif de reproduction sonore.

FIG. 1

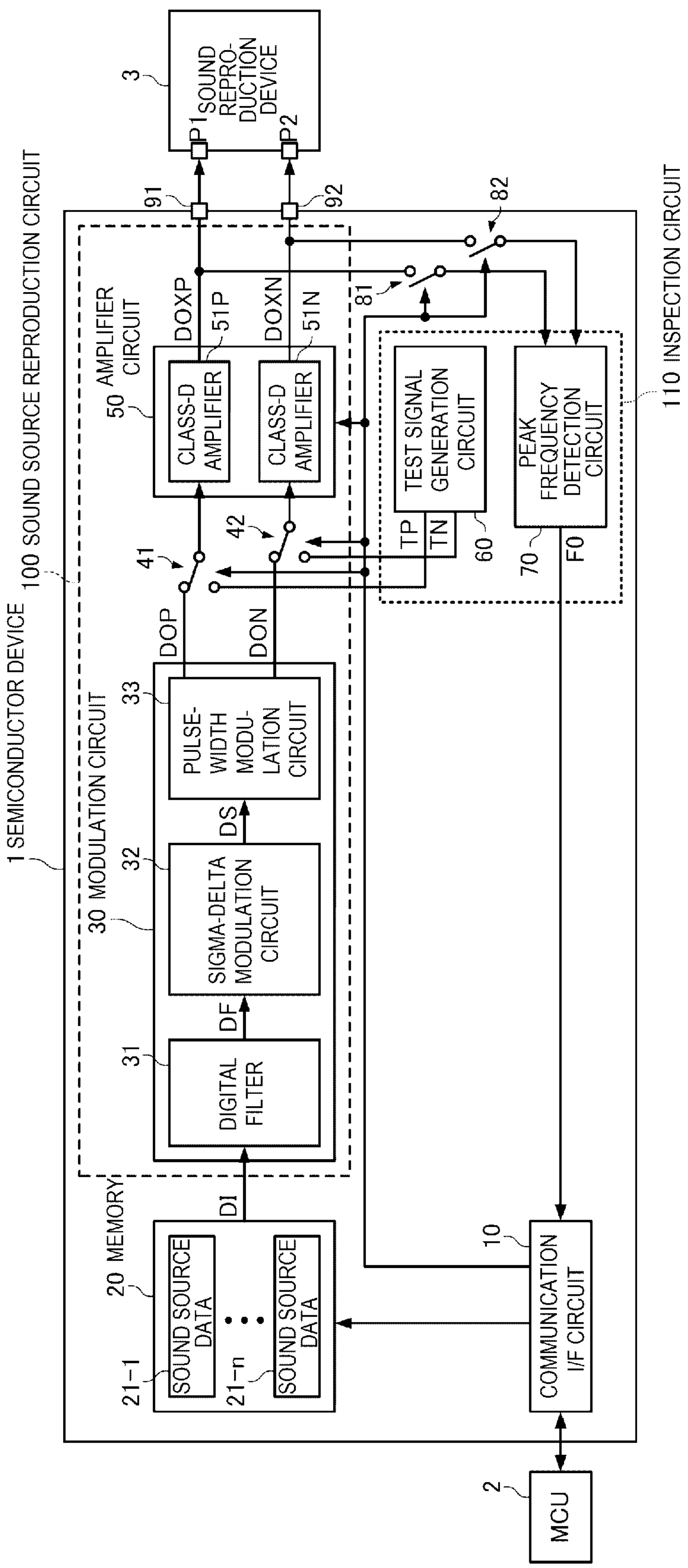
1 SEMICONDUCTOR DEVICE
100 SOUND SOURCE REPRODUCTION CIRCUIT
2
MCU
3
SOUND REPRO-DUCTION DEVICE
P1
P2
91
92
10
COMMUNICATION I/F CIRCUIT
20 MEMORY
21-1
SOUND SOURCE DATA
21-n
SOUND SOURCE DATA
DI
30 MODULATION CIRCUIT
31
DIGITAL FILTER
DF
32
SIGMA-DELTA MODULATION CIRCUIT
DS
33
PULSE-WIDTH MODU-LATION CIRCUIT
DOP
DON
41
42
50 AMPLIFIER CIRCUIT
CLASS-D AMPLIFIER
CLASS-D AMPLIFIER
51P
51N
DOXP
DOXN
81
82
110 INSPECTION CIRCUIT
60
TEST SIGNAL GENERATION CIRCUIT
TP
TN
70
PEAK FREQUENCY DETECTION CIRCUIT
F0

FIG. 2

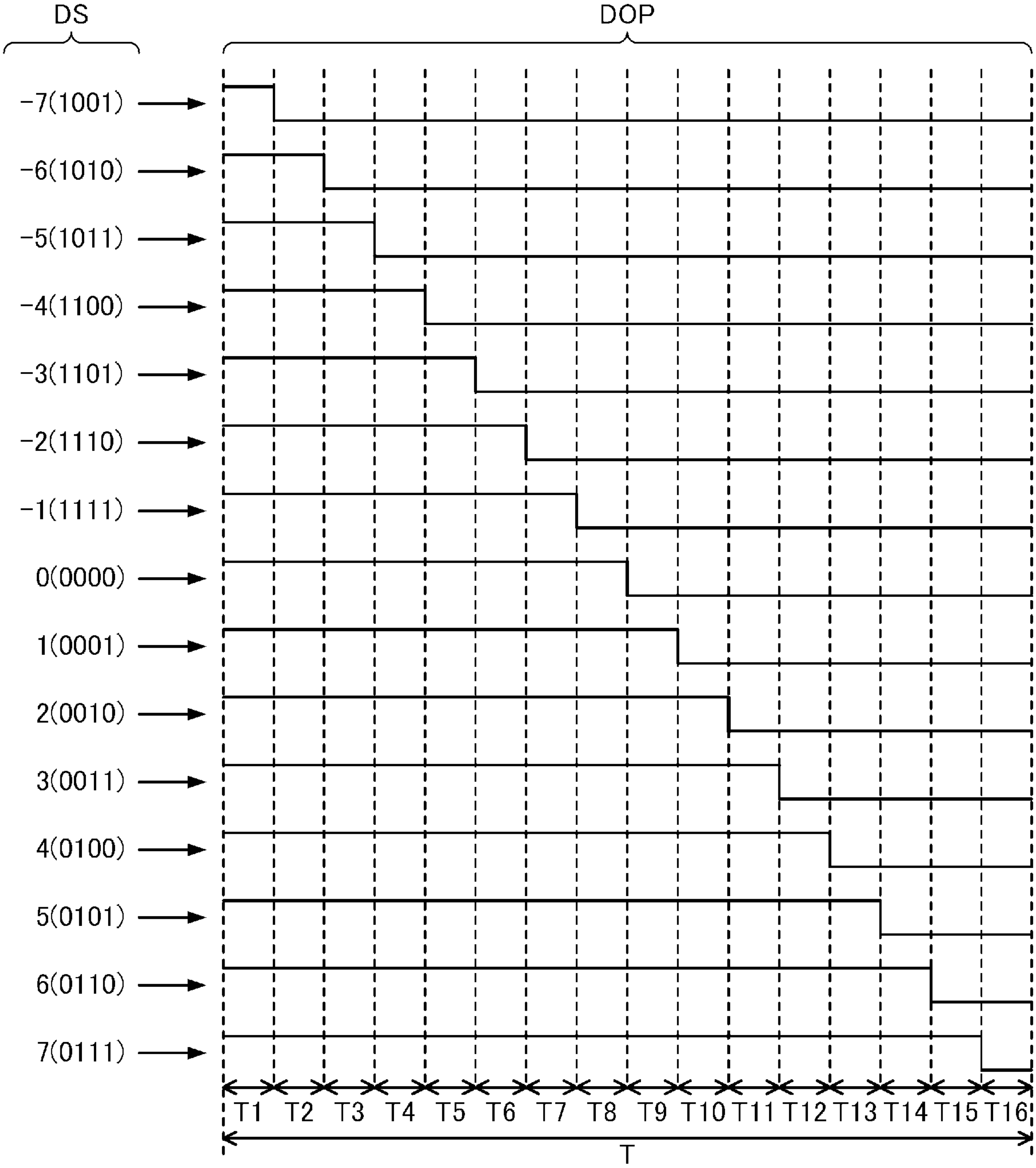
DS
DOP
-7(1001)
-6(1010)
-5(1011)
-4(1100)
-3(1101)
-2(1110)
-1(1111)
0(0000)
1(0001)
2(0010)
3(0011)
4(0100)
5(0101)
6(0110)
7(0111)
T1 T2 T3 T4 T5 T6 T7 T8 T9 T10 T11 T12 T13 T14 T15 T16
T

FIG. 3

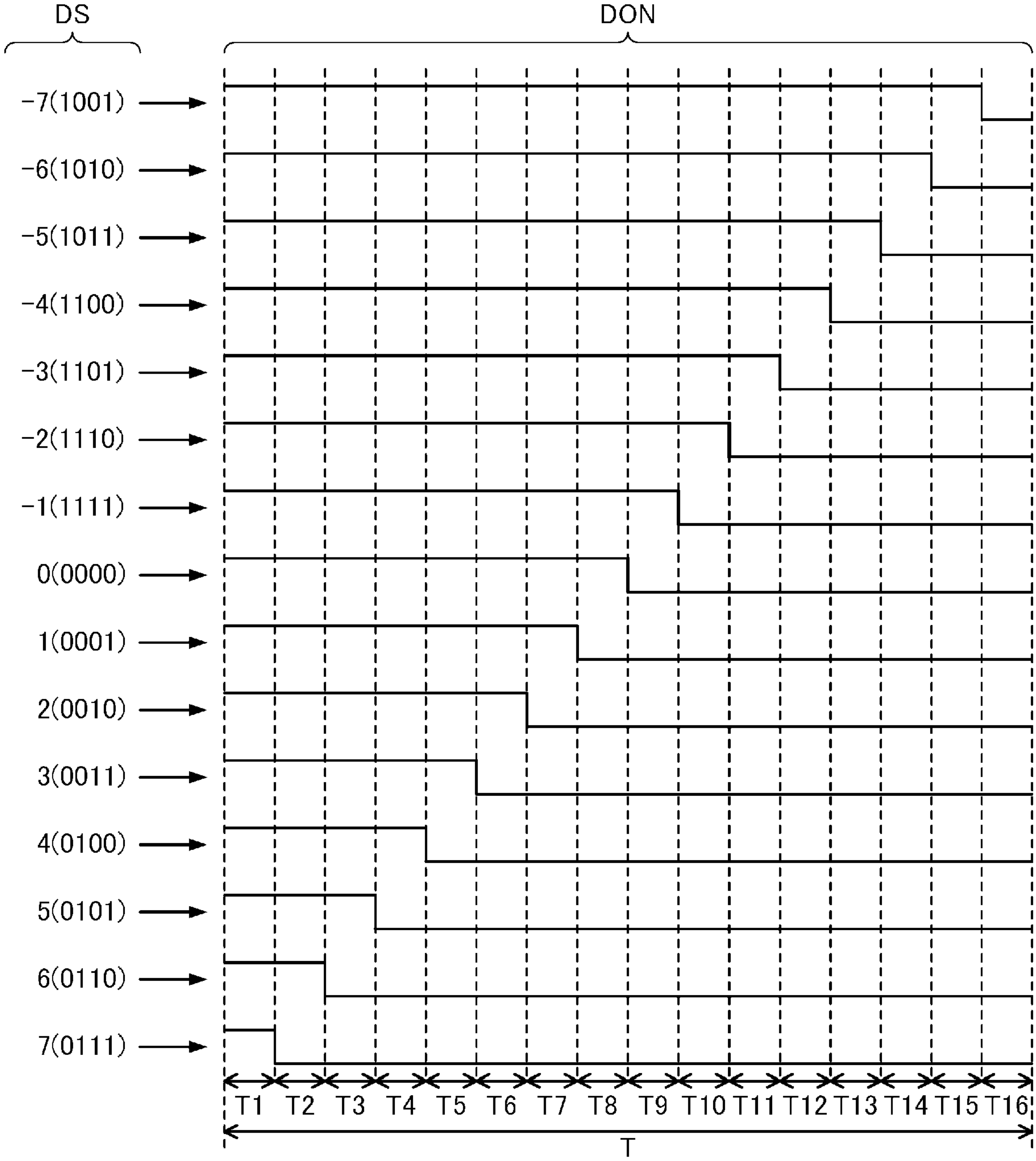
DS
DON
-7(1001)
-6(1010)
-5(1011)
-4(1100)
-3(1101)
-2(1110)
-1(1111)
0(0000)
1(0001)
2(0010)
3(0011)
4(0100)
5(0101)
6(0110)
7(0111)
T1 T2 T3 T4 T5 T6 T7 T8 T9 T10 T11 T12 T13 T14 T15 T16
T

FIG. 4

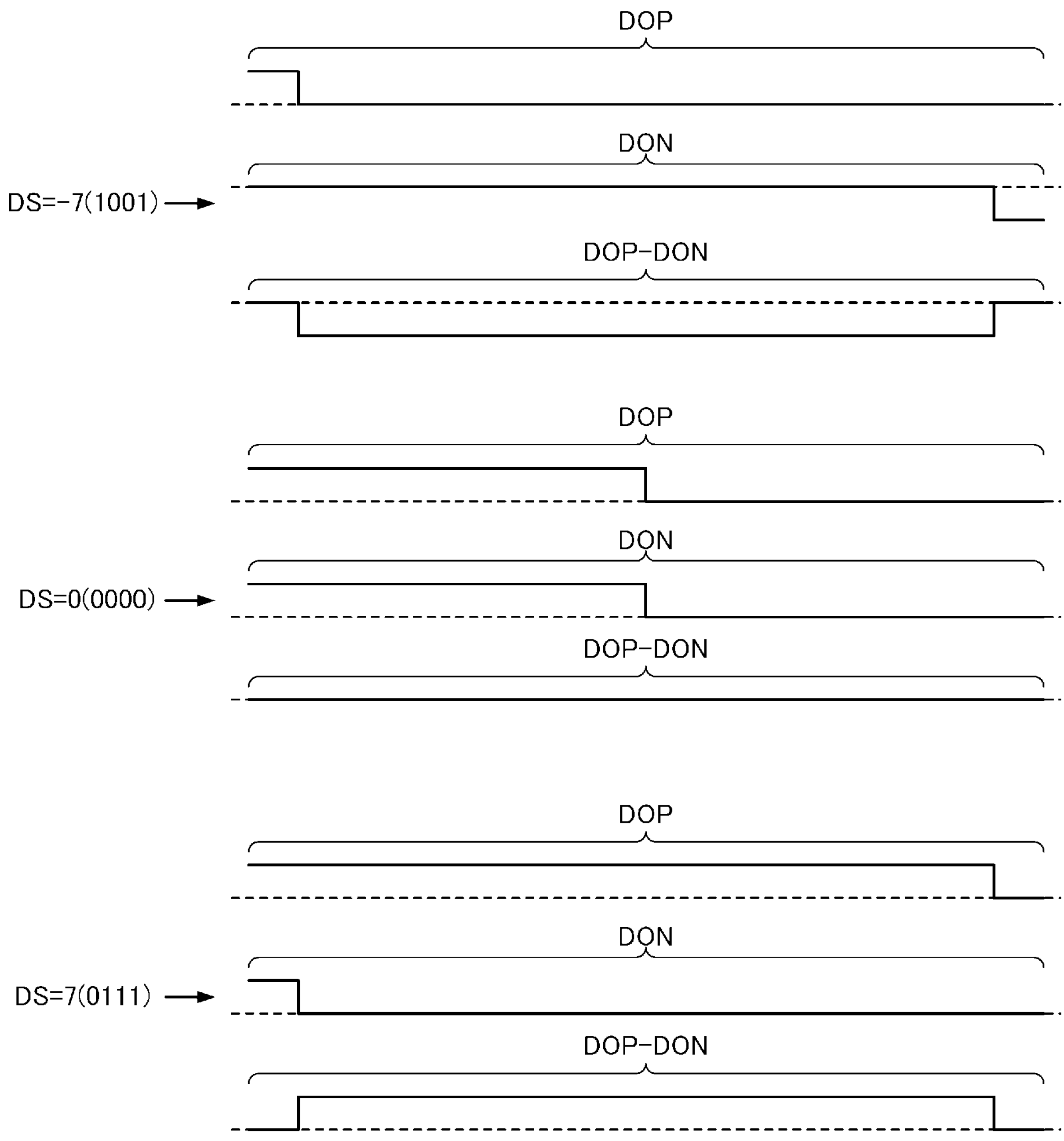
DOP
DON
DS=-7(1001)
DOP-DON
DOP
DON
DS=0(0000)
DOP-DON
DOP
DON
DS=7(0111)
DOP-DON

FIG. 5

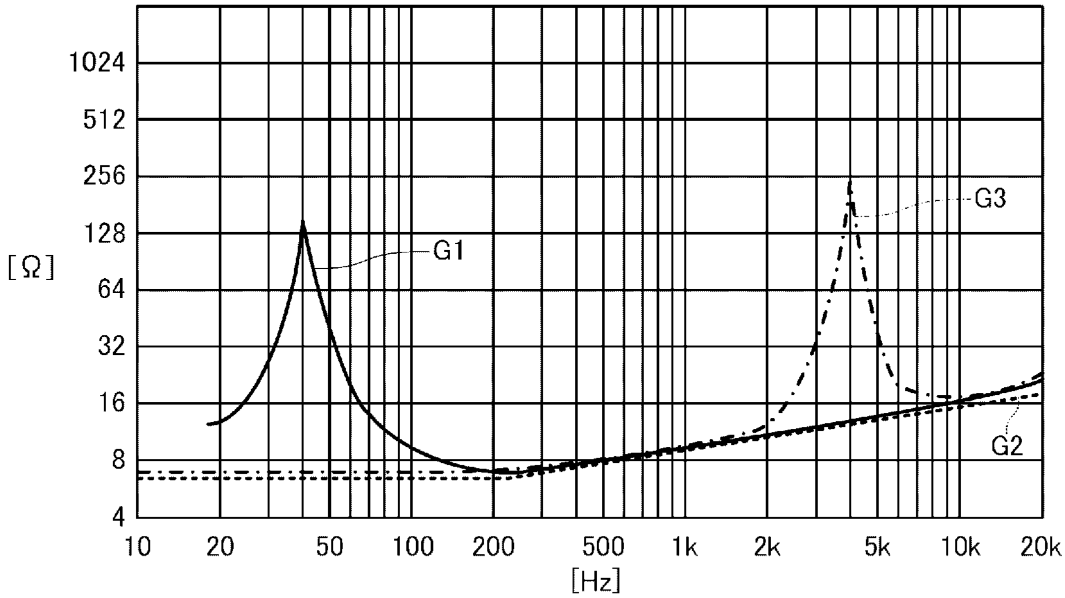
1024
512
256
128
64
32
16
8
4
[Ω]
G1
G2
G3
10
20
50
100
200
500
1k
2k
5k
10k
20k
[Hz]

FIG. 6

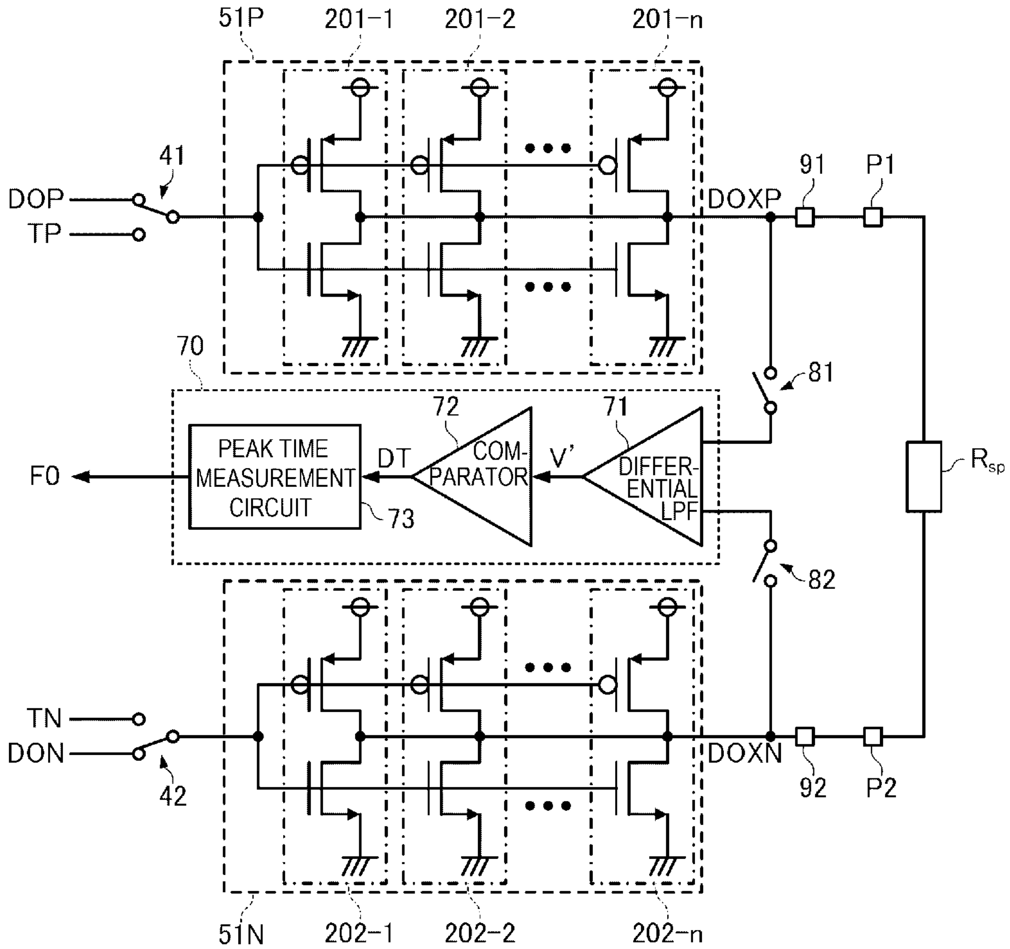
51P
201-1
201-2
201-n
41
DOP
TP
DOXP
91
P1
70
81
72
71
PEAK TIME MEASUREMENT CIRCUIT
DT
COM-PARATOR
V'
DIFFER-ENTIAL LPF
F0
73
$R_{sp}$
82
TN
DON
42
DOXN
92
P2
51N
202-1
202-2
202-n

# FIG. 7

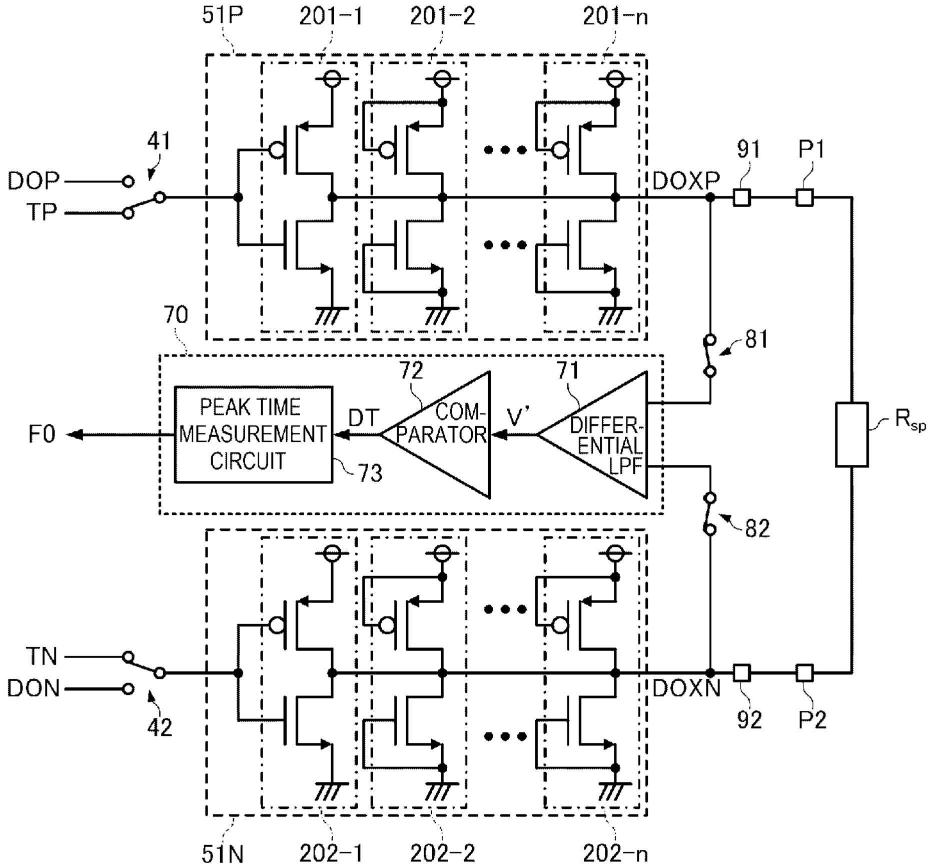
51P
201-1
201-2
201-n
41
DOP
TP
DOXP
91
P1
70
81
72
71
PEAK TIME MEASUREMENT CIRCUIT
DT
COM-PARATOR
V'
DIFFER-ENTIAL LPF
F0
73
$R_{sp}$
82
TN
DON
DOXN
42
92
P2
51N
202-1
202-2
202-n

# FIG. 8

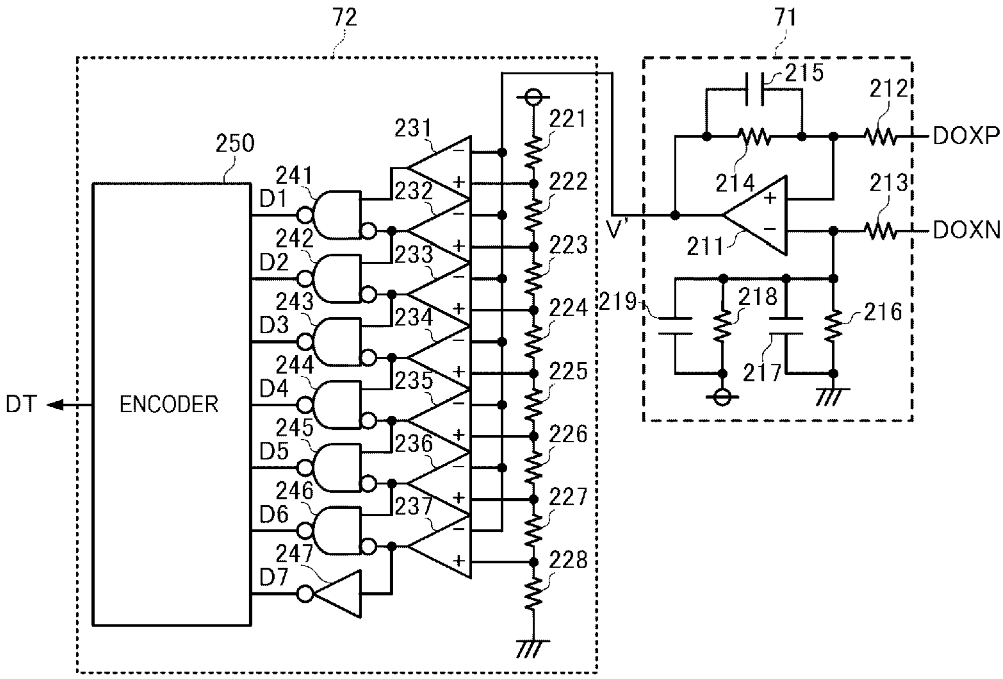
72
71
215
212
221
DOXP
231
250
241
222
D1
232
214
213
242
223
V'
211
DOXN
D2
233
243
224
219
218
216
D3
234
244
225
217
DT
ENCODER
D4
235
245
226
D5
236
246
227
D6
237
247
228
D7

# FIG. 9

| D1 | D2 | D3 | D4 | D5 | D6 | D7 | DT[2] | DT[1] | DT[0] |
|---|---|---|---|---|---|---|---|---|---|
| H | H | H | H | H | H | H | 0 | 1 | 1 |
| L | H | H | H | H | H | H | 0 | 1 | 0 |
| L | L | H | H | H | H | H | 0 | 0 | 1 |
| L | L | L | H | H | H | H | 0 | 0 | 0 |
| L | L | L | L | H | H | H | 1 | 0 | 0 |
| L | L | L | L | L | H | H | 1 | 0 | 1 |
| L | L | L | L | L | L | H | 1 | 1 | 0 |
| L | L | L | L | L | L | L | 1 | 1 | 1 |

# FIG. 10

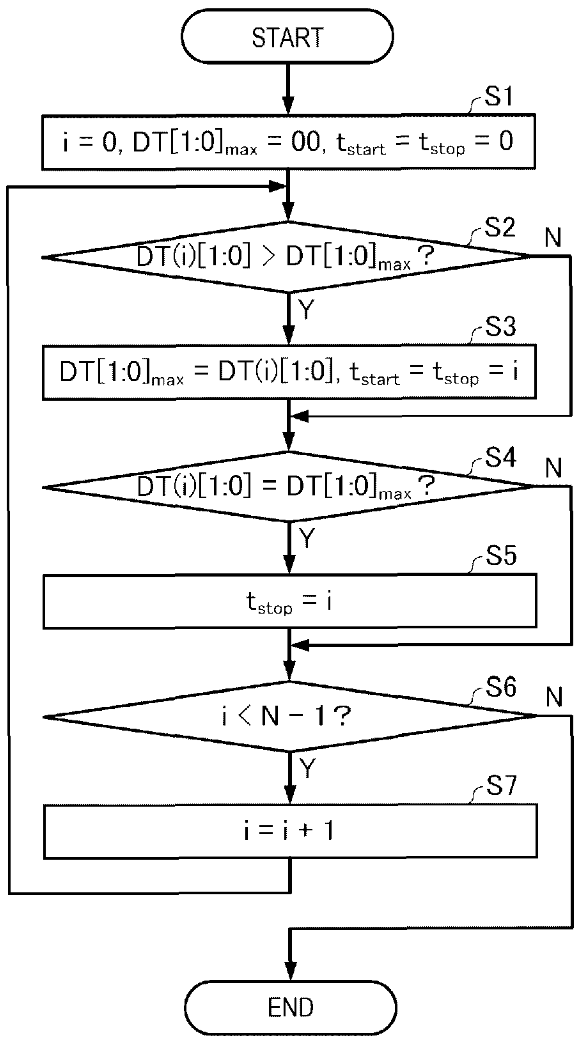

FIG. 11

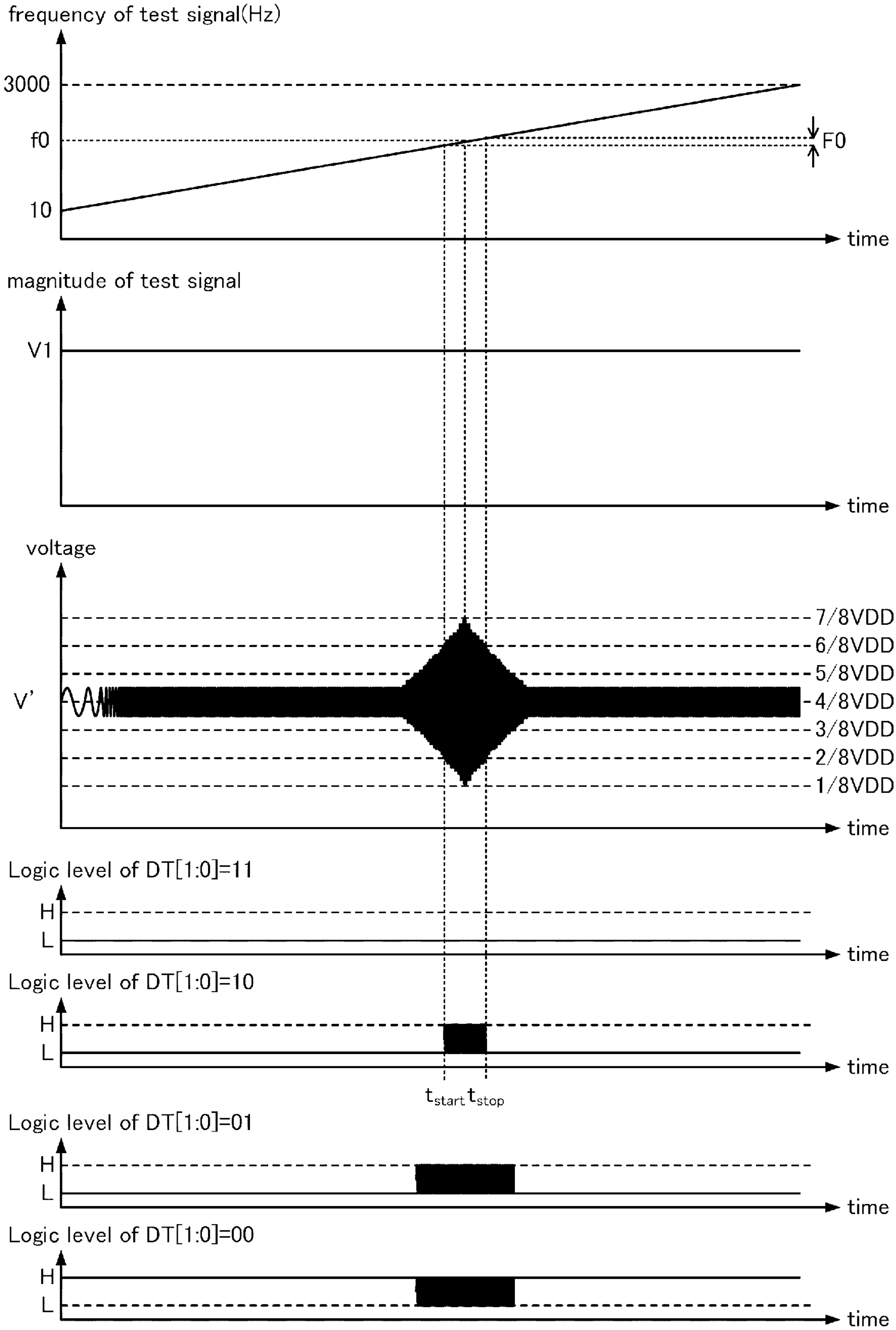
frequency of test signal(Hz)
3000
f0
10
F0
time
magnitude of test signal
V1
time
voltage
7/8VDD
6/8VDD
5/8VDD
V'
4/8VDD
3/8VDD
2/8VDD
1/8VDD
time
Logic level of DT[1:0]=11
H
L
time
Logic level of DT[1:0]=10
H
L
time
$t_{start}$ $t_{stop}$
Logic level of DT[1:0]=01
H
L
time
Logic level of DT[1:0]=00
H
L
time

FIG. 12

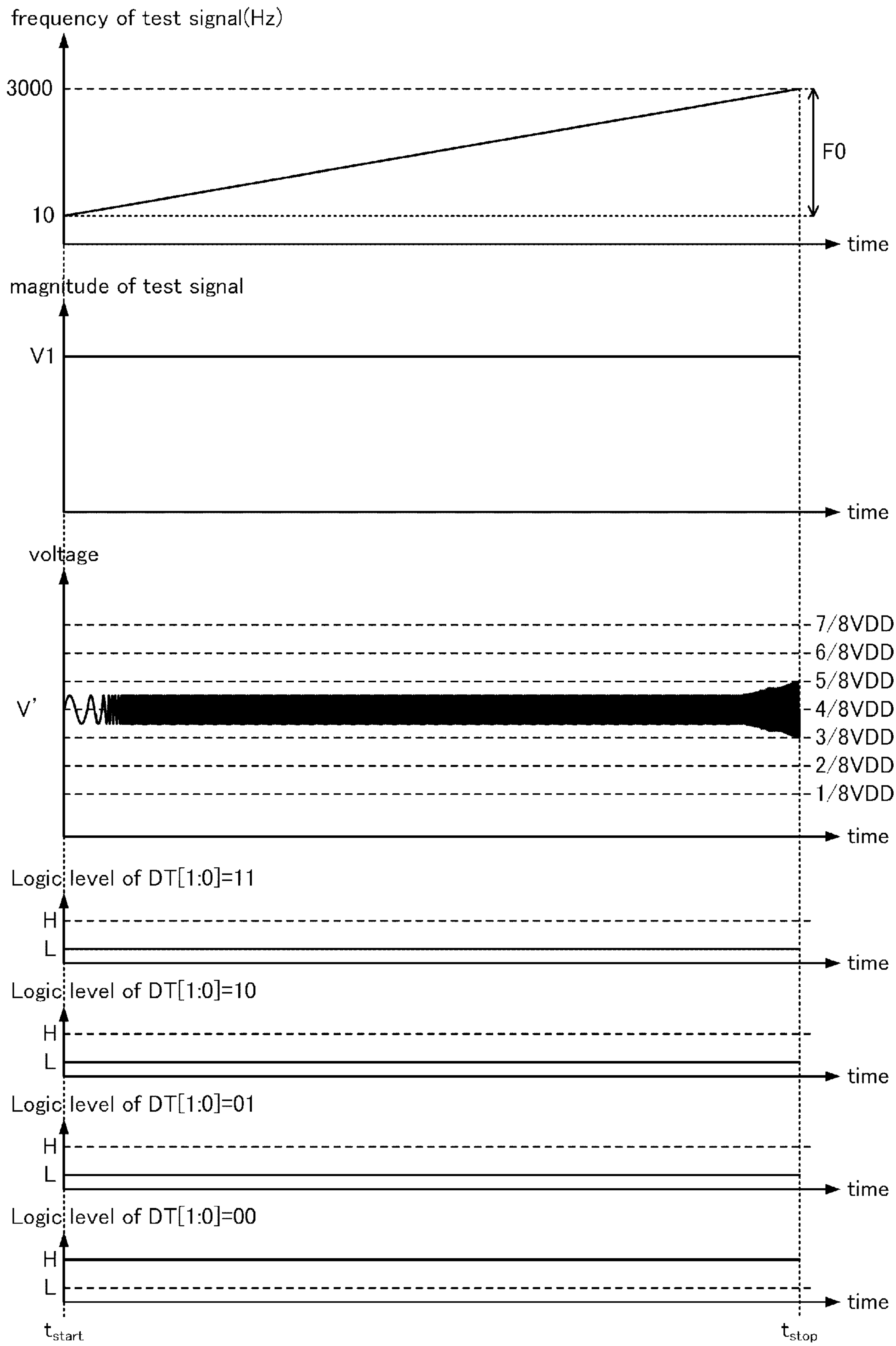
frequency of test signal(Hz)
3000
10
F0
time
magnitude of test signal
V1
time
voltage
7/8VDD
6/8VDD
5/8VDD
V'
4/8VDD
3/8VDD
2/8VDD
1/8VDD
time
Logic level of DT[1:0]=11
H
L
time
Logic level of DT[1:0]=10
H
L
time
Logic level of DT[1:0]=01
H
L
time
Logic level of DT[1:0]=00
H
L
time
tstart
tstop

# FIG. 13

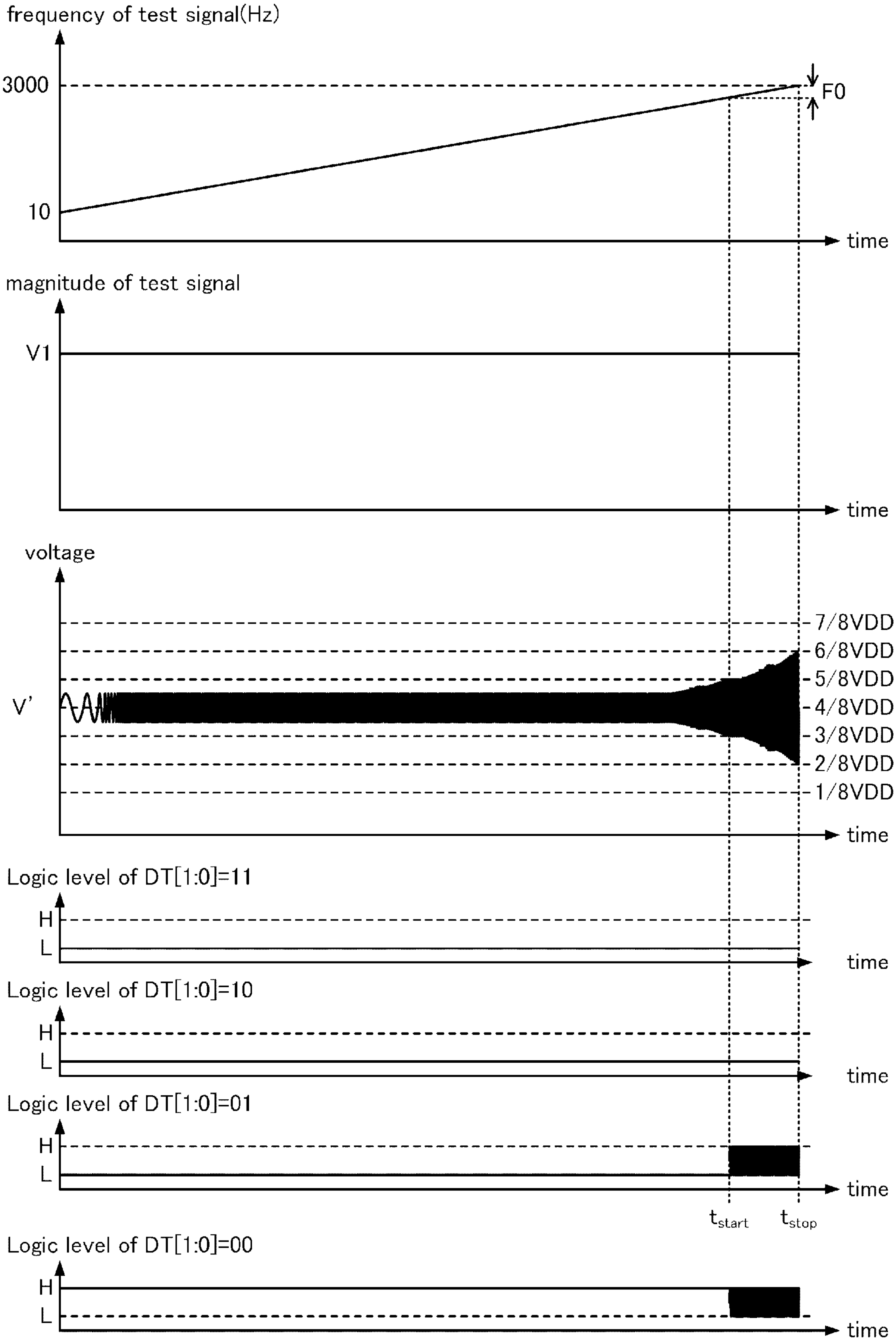
frequency of test signal(Hz)
3000
10
F0
time
magnitude of test signal
V1
time
voltage
V'
7/8VDD
6/8VDD
5/8VDD
4/8VDD
3/8VDD
2/8VDD
1/8VDD
time
Logic level of DT[1:0]=11
H
L
time
Logic level of DT[1:0]=10
H
L
time
Logic level of DT[1:0]=01
H
L
time
$t_{start}$
$t_{stop}$
Logic level of DT[1:0]=00
H
L
time

*FIG. 14*

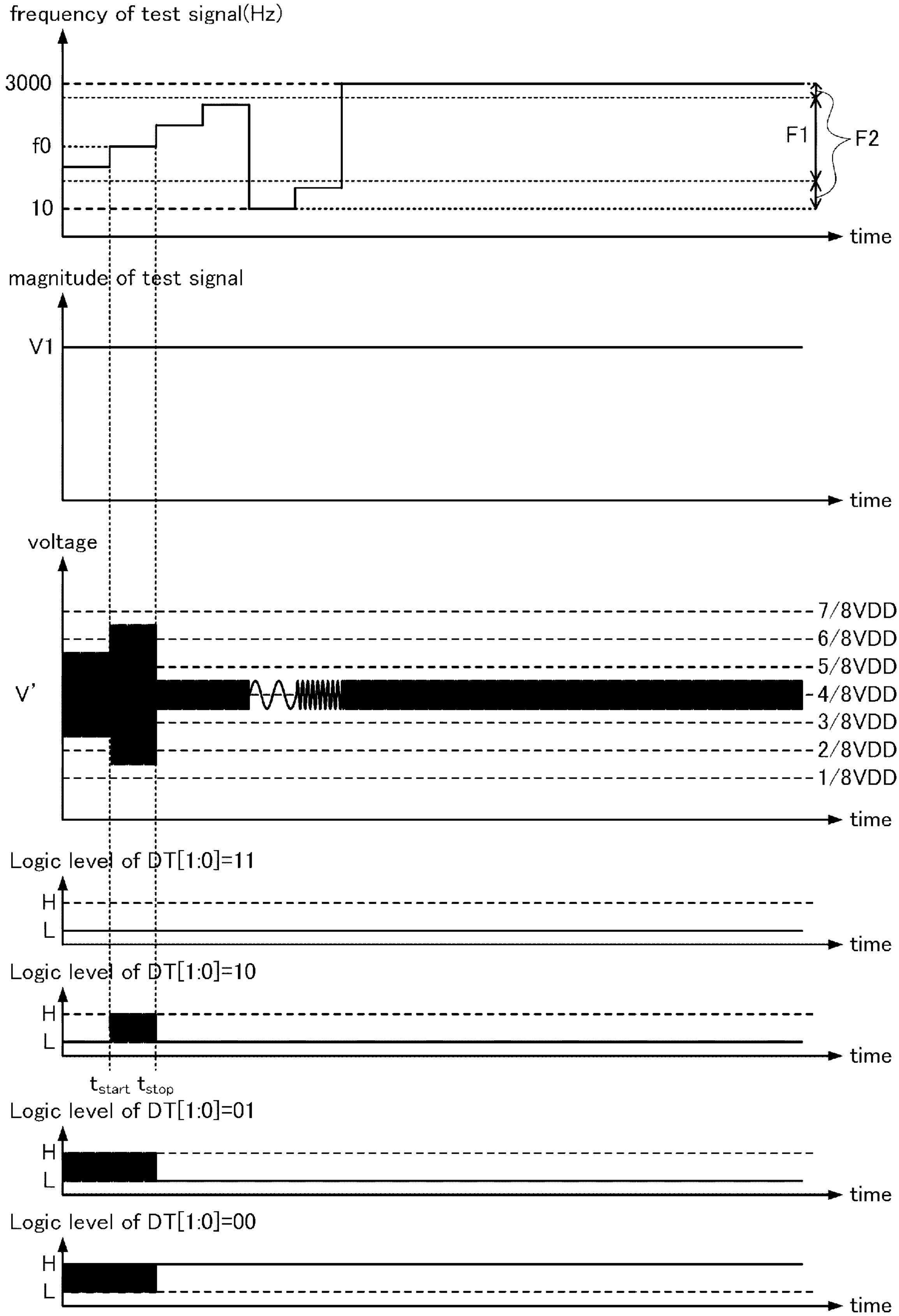
frequency of test signal(Hz)
3000
f0
10
F1
F2
time
magnitude of test signal
V1
time
voltage
V'
7/8VDD
6/8VDD
5/8VDD
4/8VDD
3/8VDD
2/8VDD
1/8VDD
time
Logic level of DT[1:0]=11
H
L
time
Logic level of DT[1:0]=10
H
L
time
tstart tstop
Logic level of DT[1:0]=01
H
L
time
Logic level of DT[1:0]=00
H
L
time

FIG. 15

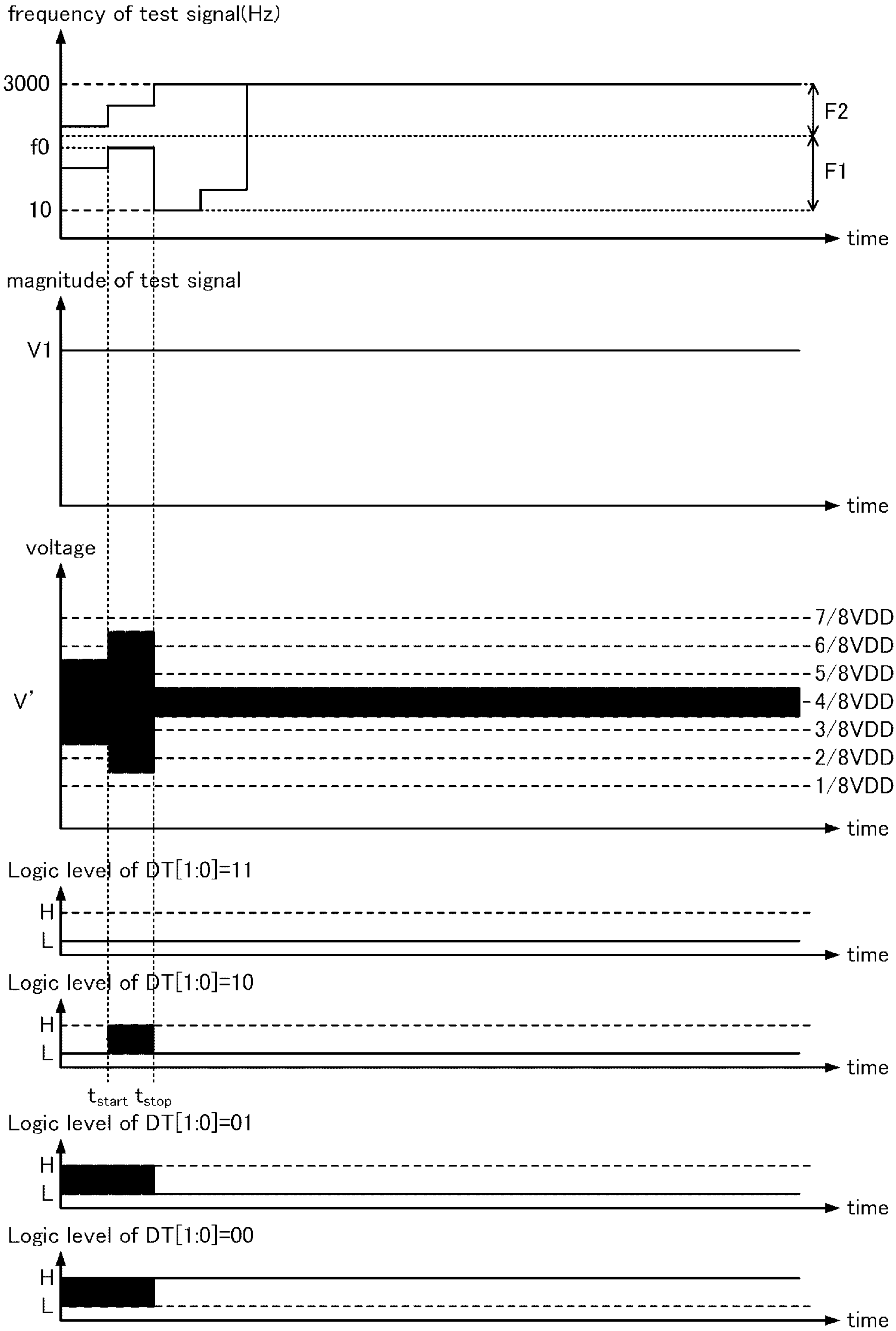

frequency of test signal(Hz)
3000
f0
10
F2
F1
time
magnitude of test signal
V1
time
voltage
V'
7/8VDD
6/8VDD
5/8VDD
4/8VDD
3/8VDD
2/8VDD
1/8VDD
time
Logic level of DT[1:0]=11
H
L
time
Logic level of DT[1:0]=10
H
L
time
$t_{start}$ $t_{stop}$
Logic level of DT[1:0]=01
H
L
time
Logic level of DT[1:0]=00
H
L
time

FIG. 16

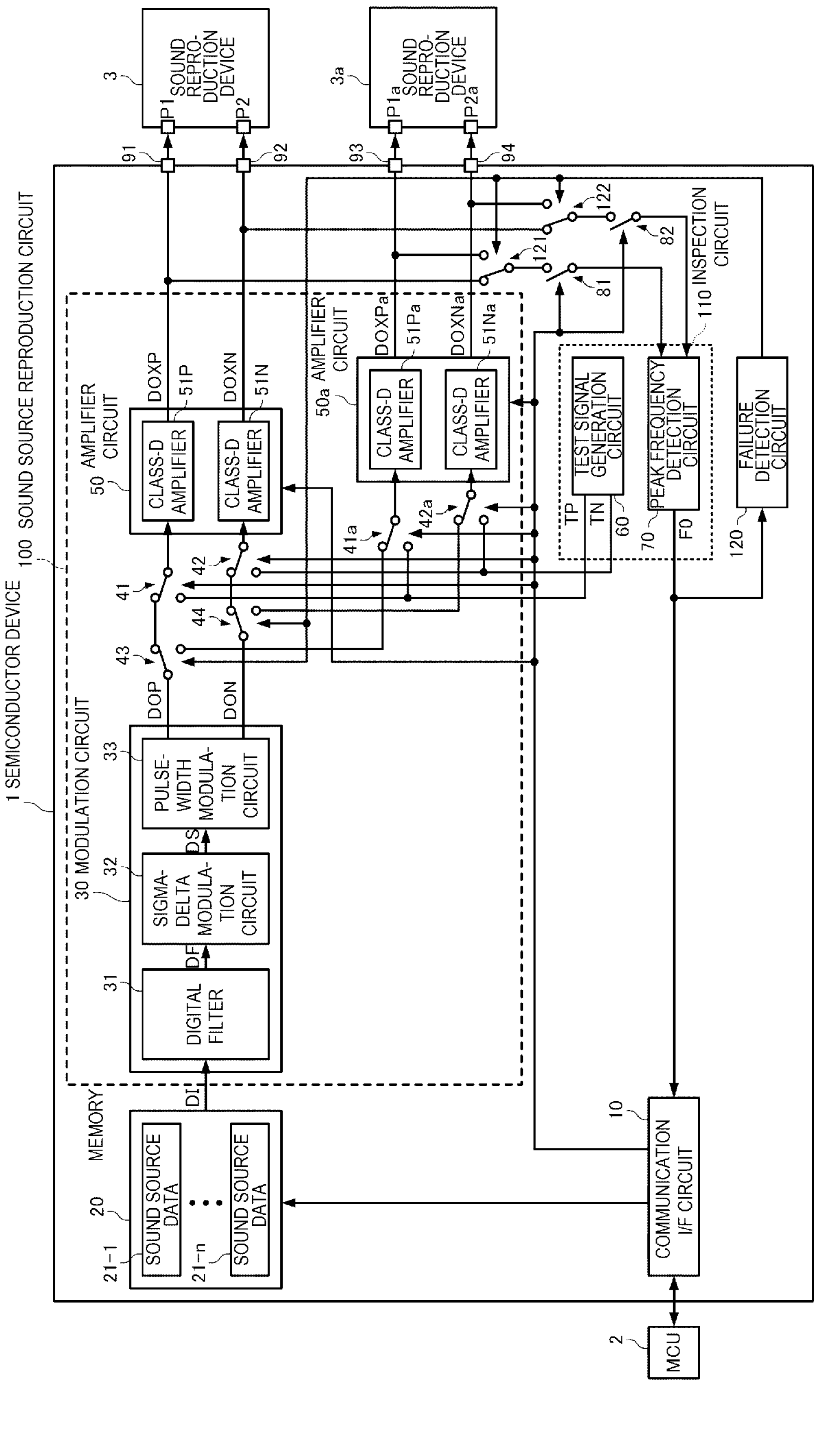
1 SEMICONDUCTOR DEVICE
100 SOUND SOURCE REPRODUCTION CIRCUIT
30 MODULATION CIRCUIT
31 DIGITAL FILTER
32 SIGMA-DELTA MODULATION CIRCUIT
33 PULSE-WIDTH MODULATION CIRCUIT
DI
DF
DS
DOP
DON
20 MEMORY
21-1 SOUND SOURCE DATA
21-n SOUND SOURCE DATA
50 AMPLIFIER CIRCUIT
51P CLASS-D AMPLIFIER
51N CLASS-D AMPLIFIER
DOXP
DOXN
50a AMPLIFIER CIRCUIT
51Pa CLASS-D AMPLIFIER
51Na CLASS-D AMPLIFIER
DOXPa
DOXNa
41
42
43
44
41a
42a
91
92
93
94
3 SOUND REPRODUCTION DEVICE
P1
P2
3a SOUND REPRODUCTION DEVICE
P1a
P2a
121
122
81
82
110 INSPECTION CIRCUIT
60 TEST SIGNAL GENERATION CIRCUIT
TP
TN
70 PEAK FREQUENCY DETECTION CIRCUIT
F0
120 FAILURE DETECTION CIRCUIT
10 COMMUNICATION I/F CIRCUIT
2 MCU

FIG. 17

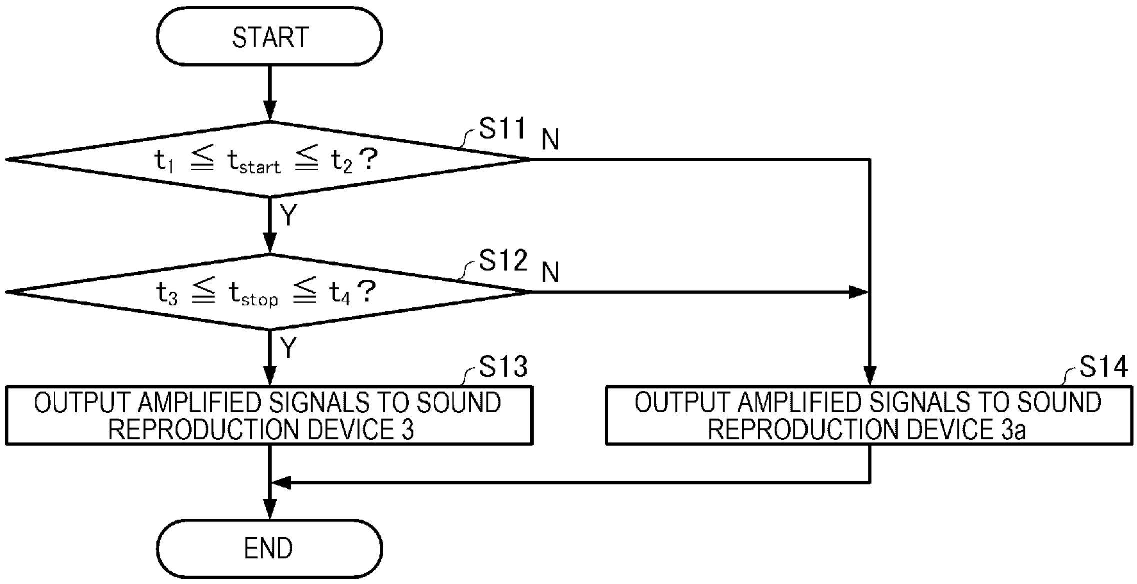
START
S11
$t_1 \leqq t_{start} \leqq t_2$?
N
Y
S12
$t_3 \leqq t_{stop} \leqq t_4$?
N
Y
S13
OUTPUT AMPLIFIED SIGNALS TO SOUND REPRODUCTION DEVICE 3
S14
OUTPUT AMPLIFIED SIGNALS TO SOUND REPRODUCTION DEVICE 3a
END

*FIG. 18*

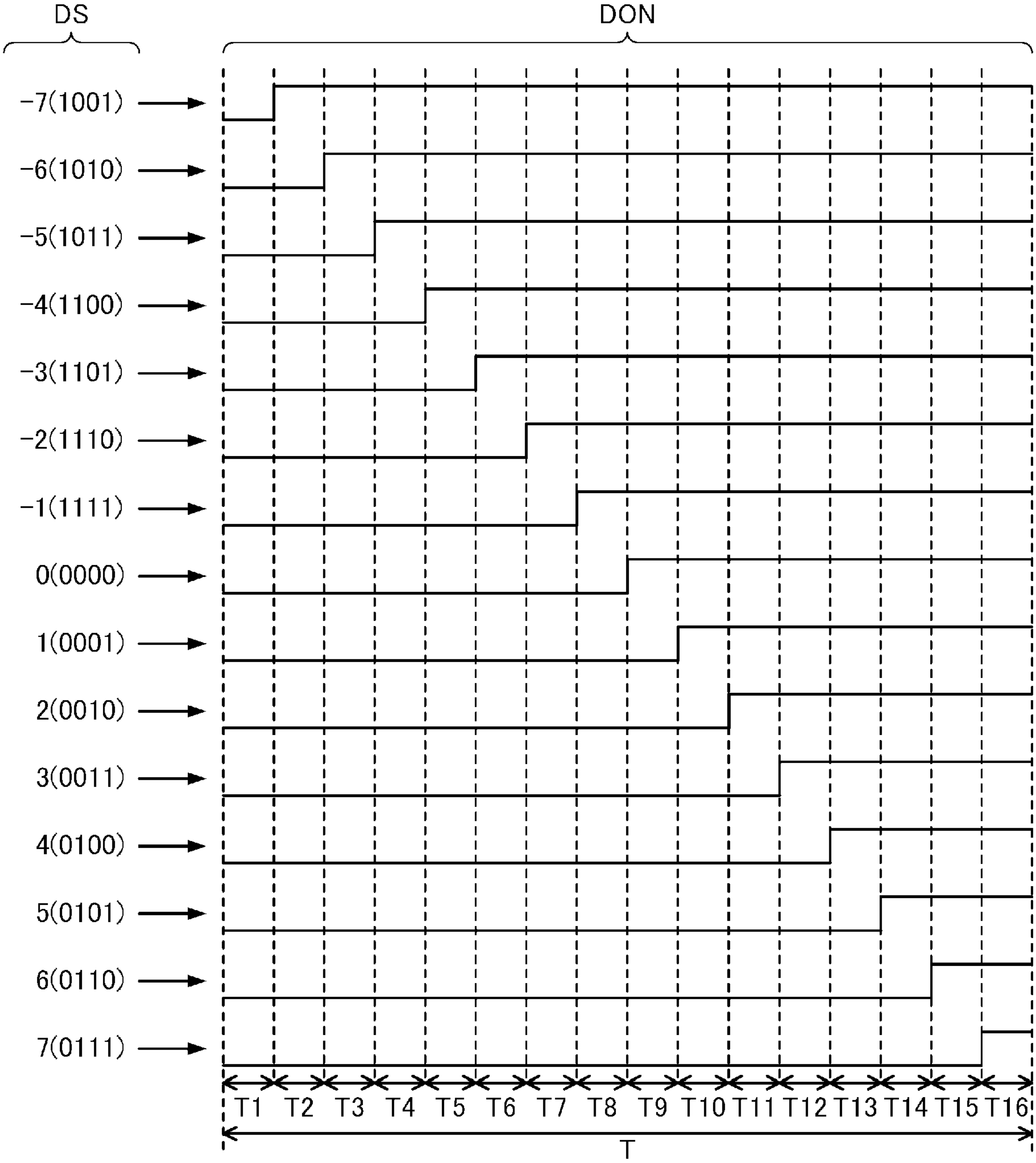
DS
DON
−7(1001)
−6(1010)
−5(1011)
−4(1100)
−3(1101)
−2(1110)
−1(1111)
0(0000)
1(0001)
2(0010)
3(0011)
4(0100)
5(0101)
6(0110)
7(0111)
T1
T2
T3
T4
T5
T6
T7
T8
T9
T10
T11
T12
T13
T14
T15
T16
T

FIG. 19

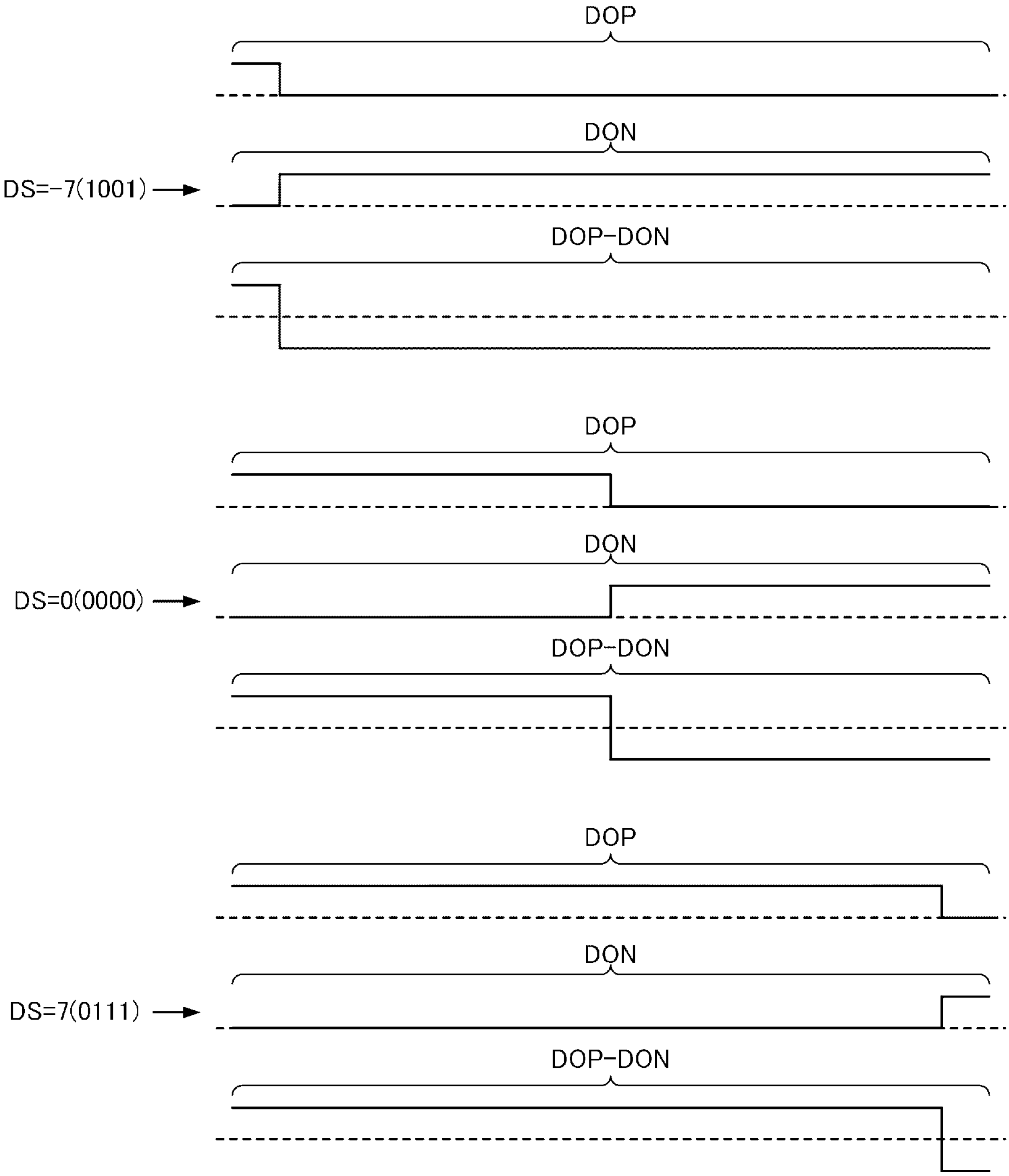
DOP
DON
DS=-7(1001)
DOP-DON
DOP
DON
DS=0(0000)
DOP-DON
DOP
DON
DS=7(0111)
DOP-DON

FIG. 20

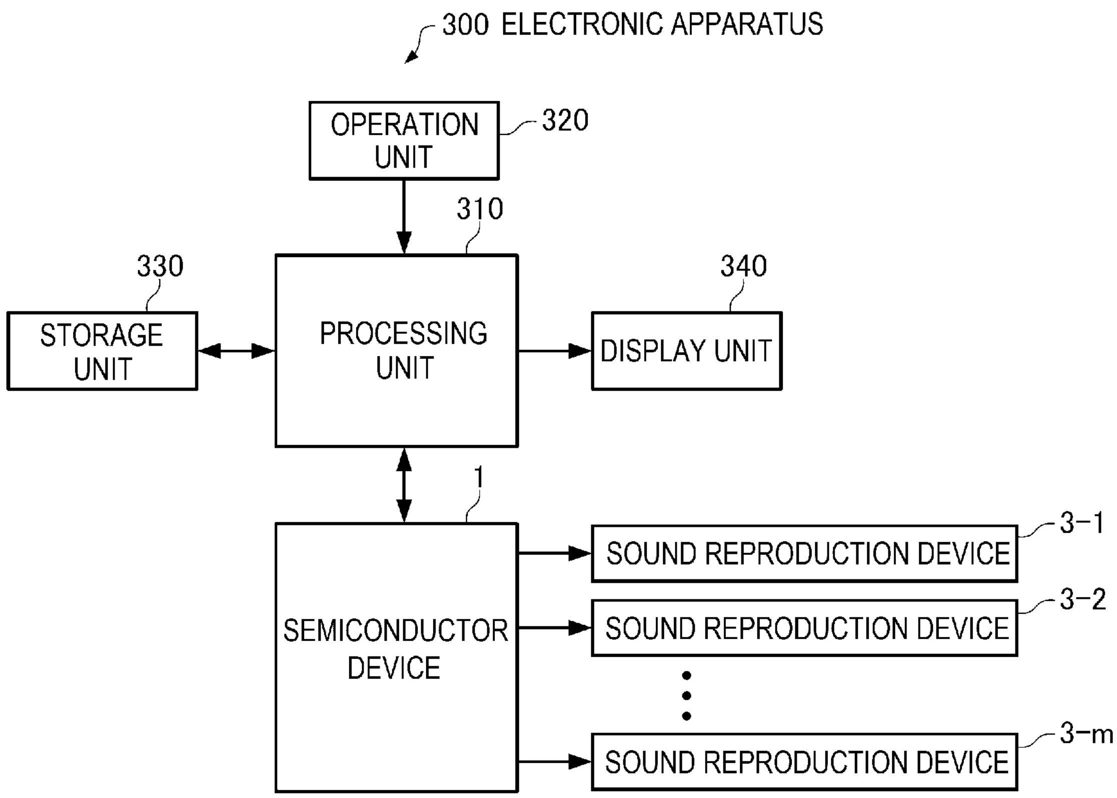
300 ELECTRONIC APPARATUS
OPERATION UNIT
320
310
330
340
STORAGE UNIT
PROCESSING UNIT
DISPLAY UNIT
1
SEMICONDUCTOR DEVICE
SOUND REPRODUCTION DEVICE
3-1
SOUND REPRODUCTION DEVICE
3-2
SOUND REPRODUCTION DEVICE
3-m

FIG. 21

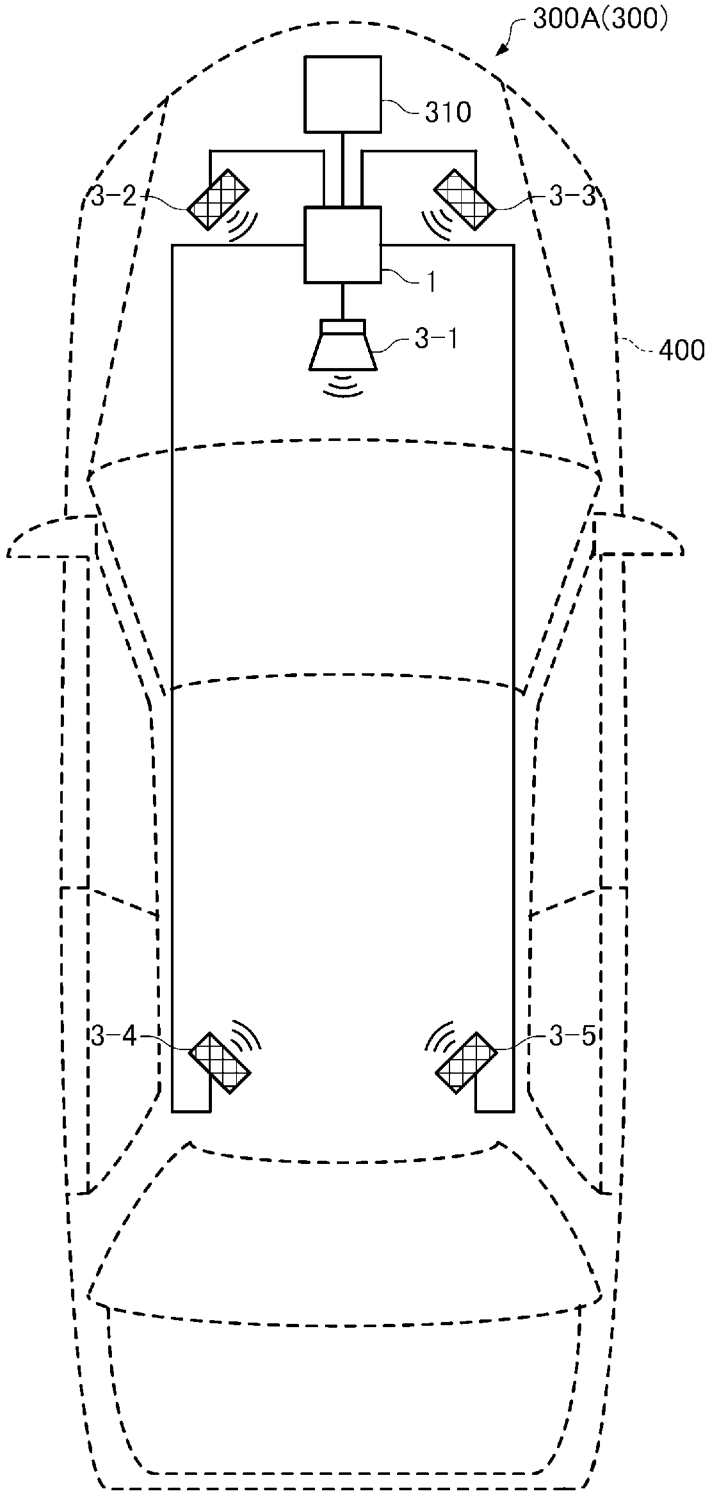

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2012199854 A
- US 2015030167 A1
- US 2012294450 A1
- US 2011241774 A1
- US 2022086577 A1